(19) Europäisches Patentamt
European Patent Office
Office européen des brevets

(11) **EP 4 437 353 B1**

(12) **EUROPÄISCHE PATENTSCHRIFT**

(45) Veröffentlichungstag und Bekanntmachung des Hinweises auf die Patenterteilung:
**15.01.2025 Patentblatt 2025/03**

(21) Anmeldenummer: **23709696.1**

(22) Anmeldetag: **07.03.2023**

(51) Internationale Patentklassifikation (IPC):
**G01R 33/38** $^{(2006.01)}$   **G01R 33/383** $^{(2006.01)}$
**H01F 7/02** $^{(2006.01)}$

(52) Gemeinsame Patentklassifikation (CPC):
**G01R 33/3802; G01R 33/383; H01F 7/0221; H01F 7/0278**

(86) Internationale Anmeldenummer:
**PCT/EP2023/055679**

(87) Internationale Veröffentlichungsnummer:
**WO 2023/170030 (14.09.2023 Gazette 2023/37)**

(54) **NMR PERMANENTMAGNET IN HALBACH-ANORDNUNG BASIEREND AUF SEGMENTEN MIT REGULÄRER POLYEDERGEOMETRIE SOWIE HERSTELLUNGSVERFAHREN**

**NMR PERMANENT MAGNET IN HALBACH ARRAY, BASED ON SEGMENTS WITH REGULAR POLYHEDRON GEOMETRY, AND METHOD OF MANUFACTURE**

**AIMANT PERMANENT RMN EN CONFIGURATION DE RÉSEAU DE HALBACH À BASE DE SEGMENTS À GÉOMÉTRIE POLYÉDRIQUE RÉGULIÈRE ET PROCÉDÉ DE FABRICATION**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **10.03.2022 DE 102022202399**

(43) Veröffentlichungstag der Anmeldung:
**02.10.2024 Patentblatt 2024/40**

(73) Patentinhaber: **Bruker BioSpin GmbH**
**76275 Ettlingen (DE)**

(72) Erfinder: **HÄNICHEN, Lukas**
**76137 Karlsruhe (DE)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**US-A- 5 705 902**

• BAUN OLGA ET AL: "Permanent magnet system to guide superparamagnetic particles", JOURNAL OF MAGNETISM AND MAGNETIC MATERIALS, ELSEVIER, AMSTERDAM, NL, vol. 439, 4 May 2017 (2017-05-04), pages 294 - 304, XP085050068, ISSN: 0304-8853, DOI: 10.1016/J.JMMM.2017.05.001
• BLÜMLER PETER: "Proposal for a permanent magnet system with a constant gradient mechanically adjustable in direction and strength", CONCEPTS IN MAGNETIC RESONANCE PART B: MAGNETIC RESONANCE ENGINEERING, vol. 46, no. 1, 27 February 2016 (2016-02-27), US, pages 41 - 48, XP055969504, ISSN: 1552-5031, DOI: 10.1002/cmr.b.21320
• RAICH H ET AL: "Design and construction of a dipolar Halbach array with a homogeneous field from identical bar magnets: NMR Mandhalas", CONCEPTS IN MAGNETIC RESONANCE, NMR CONCEPTS, KINGSTON, RI, US, vol. 23B, no. 1, 1 January 2004 (2004-01-01), pages 16 - 25, XP008084096, ISSN: 1043-7347

- ANONYMOUS: "Neodymium magnet - Wikipedia", 31 August 2012 (2012-08-31), XP055317685, Retrieved from the Internet <URL:https://en.wikipedia.org/w/index.php?title=Neodymium_magnet&oldid=510085390> [retrieved on 20161109]

**Beschreibung**

Die Erfindung betrifft ein Permanentmagnetsystem mit einer ringförmig um eine z-Achse aufgebauten Magnetanordnung zur Erzeugung eines homogenen Magnetfeldes in einer Richtung senkrecht zur z-Achse in einem Messvolumen innerhalb der ringförmigen Magnetanordnung, welche mindestens ein ringförmiges Magnetelement mit magnetischem Material in einer Ringebene umfasst, das in einer Halbach-Konfiguration eine Anzahl n nebeneinander sowie jeweils mit Flächenanlage angeordnete einzelne Magnetsegmente aufweist, die im Umlauf um das ringförmige Magnetelement gemäß den Regeln einer Halbach-Anordnung sich ändernde Magnetisierungsrichtungen haben, die zusammen ein magnetisches Dipolfeld in der Ringebene der ringförmigen Magnetanordnung erzeugen, und die untereinander gleiche polyedrische Geometrie und in der Ringebene jeweils einen identischen, konvexen, regelmäßig polygonalen Querschnitt aufweisen.

Eine solche Magnetanordnung ist bekannt aus der US 8,712,706 B2 (= Referenz [1]) oder aus der US 9,952,294 B2 (= Referenz [2]).

Hintergrund der Erfindung

Die vorliegende Erfindung betrifft allgemein den Bereich des Magnetbaus, insbesondere des Designs und der Herstellung von Magnetanordnungen. Des Weiteren befasst sich die Erfindung -zumindest indirekt- aber auch mit dem Gebiet der Magnetresonanz (="MR"), insbesondere mit der Bereitstellung von Magnetanordnungen, die zur Erzeugung von homogenen Magnetfeldern für NMR-Messungen einsetzbar sind. Die Anwendbarkeit der Erfindung ist jedoch nicht auf diese Spezialgebiete beschränkt.

Sowohl im Bereich der Kernresonanzspektroskopie (="NMR-Spektroskopie") als auch bei der bildgebenden Anwendung (="MRI") wird in einem zu definierenden Probenvolumen ein sehr homogenes und zeitlich konstantes Magnetfeld benötigt, welches mit resistiven oder supraleitenden Spulen oder einer geeigneten Permanentmagnetanordnung erzeugt werden kann. Die Verwendung von Permanentmagneten wird bevorzugt, wenn Flussdichten von unterhalb 2T ausreichend sind und ein vergleichsweise kompakter Aufbau erwünscht ist.

Permanentmagnete für MR Anwendungen nutzen häufig Halbach-gemäße oder Halbach-ähnliche Ringanordnungen, um einen besonders kompakten Aufbau zu erzielen. Eine der wesentlichen Voraussetzungen hierfür ist die graduelle Variation der Magnetisierungsrichtung. Typischerweise werden ringförmige Halbach-Dipole derart aufgebaut, dass einzelne Magnetsegmente mit variierenden Magnetisierungsrichtungen zu einem Halbach-Ring aneinandergefügt werden, wobei sich die Magnetisierungsrichtung im Azimutwinkel verändert. Die Ring-Anordnungen werden also aus Segmenten mit unterschiedlicher Magnetisierungsrichtung zusammengesetzt, was üblicherweise eine Vielzahl von Segmenttypen unterschiedlicher magnetischer Vorzugsrichtung erfordert.

In früheren Publikationen der Anmelderin, beispielsweise in EP 3 657 194 B1 ≈ US 10,976,391 B2 (= Referenz [3]), werden MR-taugliche Halbach-Anordnungen beschrieben, bei denen die ringförmigen Magnetelemente aus einzelnen Magnetsegmenten aufgebaut sind, die so angeordnet sind, dass die fertigen Magnetelemente eine Halbach-Magnetisierung aufweisen, welche ein magnetisches Dipolfeld erzeugt. Die gemäß Referenz [3] hierfür eingesetzten einzelnen Magnetsegmente sind dabei geometrisch als hohle Kreiszylinder oder Kreiszylindersegmente aufgebaut.

Anstelle von Kreiszylindersegmenten werden die ringförmigen Magnetelemente in der EP 3 614 162 A1 ≈ US 11,193,998 B2 (=Referenz [4]) aus polygonalen Magnetsegmenten aufgebaut, die einen trapezförmigen, sich zur z-Achse der Magnetanordnung hin verjüngenden Querschnitt aufweisen, und so an die Geometrie von Kreiszylindersegmenten angenähert sind, dass damit ein angenäherter Halbach-Ring aufgebaut werden kann.

Die eingangs zitierte Referenz [2] beschreibt ebenfalls Magnetanordnungen mit einer Vielzahl von polyedrischen Magneten als Magnetsegmenten, die in einer Gitterkonfiguration angeordnet sind und zumindest teilweise ein Testvolumen umschließen, wobei die Magnetanordnung ein zugeordnetes Magnetfeld mit einer bestimmten Feldrichtung aufweist. Die Magnetisierungsrichtung der einzelnen Polyedermagnete und deren Anordnung ist dergestalt, dass das entstehende magnetische Feld eine Halbach-Kugel approximiert.

In der US 2010/013473 A1 (=Referenz [5]) wird ein NMR Permanentmagnet vorgeschlagen mit einer Halbach-Architektur aus drei Ringen, wobei ein zentraler Magnetring axial von zwei Kopfringen flankiert wird. Die Ringe bestehen aus Einzelsegmenten, deren Querschnitte abwechselnd trapezförmig und rechteckig sind, wobei die einzelnen Segmente zur Feldhomogenisierung in Radialrichtung verschiebbar sind. Die Verwendung von nur einer Sorte untereinander gleicher Einzelsegmente mit insbesondere jeweils gleichem polygonalem Querschnitt ist in Referenz [5] allerdings nicht offenbart.

In der US 5,119,057 A (=Referenz [6]) wird zwar eine zweidimensionale Grundgeometrie mit mehreren Arten prismatischer Permanentmagnete beschrieben, es ist aber auch eine dritte Type magnetisierbaren Materials Bestandteil dieses Konzepts, welches die Funktion eines Jochs hat. Für die Einzelsegmente werden allerdings nicht identische Elemente mit untereinander gleichem polygonalen Querschnitt verwendet, sondern Geometrien mit unterschiedlichen und zumeist unregelmäßigen Polygonen.

Polygonale Magnetsegmente mit quadratischer Grund- und Querschnittsfläche werden in den folgenden Dokumenten beschrieben:

WO 2007/120057 A1 (=Referenz [7]): Hier wird eine Stapelung von Ringbaugruppen beschrieben, wobei Spalte ("Separation") zwischen den Ringbaugruppen so eingestellt werden, dass die zonalen höheren Ordnungen verschwinden. Je mehr Freiheitsgrade durch Hinzufügen weiterer Ringbaugruppen entstehen, desto mehr Ordnungen lassen sich damit shimmen. Dieses Konzept geht eher in die Richtung "drehbar gelagerte Ringbaugruppen".

EP 2 365 353 A1 (=Referenz [8]): Hier wird zudem eine Montagemethode beschrieben, die verhindern soll, dass sich bei der Montage eines aus mehreren Segmenten bestehenden Permanentmagneten einzelne Segmente bewegen bzw. aus dem Verbund lösen. Dies ist ein wichtiger Aspekt, da Sicherheit und Funktion nicht gewährleistet werden können. Derartige Maßnahmen sind üblicher Bestandteil einer Montage mit magnetischen Bauteilen.

WO 2013/187924 A1 (=Referenz [9]): Hier stehen gegeneinander rotierbare Halbach-Ringbaugruppen im Mittelpunkt; die Ausgestaltung der Ringbaugruppen ist nicht näher spezifiziert. Für das beschriebene Verfahren wird eine Verstellbarkeit des magnetischen Feldes benötigt, was durch eine rotatorische Verstellung erreicht wird.

US 2018/0313920 A1 (=Referenz [10]): In den Zeichnungen sehen die Einzelmagneten aus wie Zylinder, die zu einem Gesamtmagneten zusammengefügt werden. In der Beschreibung heißt es aber, dass die Einzelmagnete auch eine hexagonale Grundstruktur haben kann, welche jedoch nicht näher definiert wird.

Bei quadratischen Prismen für einen Halbach-Ring ist problematisch, dass diese Prismen beim Aufbau eines Rings nicht großflächig aneinander anliegen können, weshalb der resultierende Füllfaktor schlecht ist. Für die Polygone sollte daher immer eine Anzahl von mehr als vier Ecken angestrebt werden.

In der eingangs zitierten Referenz [2] ist die Rede von einer Anordnung bestehend aus einer Vielzahl polyedrischer Magnete, also mehreckiger Magnete, die die von HALBACH vorgeschlagene Magnetisierung aufweisen. Die hier vorgeschlagene Magnetisierung ist der sphärische HALBACH Dipol (3D). Die darin genannte Formel ist lediglich eine Darstellungsweise der von HALBACH vorgeschlagenen Magnetisierung eines Punktdipols im Raum, um im Innenraum ein homogenes Dipolfeld zu erzeugen, und zwar bei feldfreiem Außenraum. Könnte man mit vertretbarem Aufwand kontinuierliche - also nicht diskret zusammengesetzte - Strukturen bauen, die dieser Bedingung genügen, so wäre das Magnetmaterial tatsächlich mit maximaler Effizienz nutzbar. Das heißt aber auch, dass der Magnetisierungsvektor in jedem Raumpunkt einen anderen Wert nach Richtung und/oder Betrag annimmt, was jedoch eben im Widerspruch zu einem vertretbaren Aufwand bei der Herstellung stünde.

Neben allerlei räumlich etwas exotischer geformten Magnetsegmenten werden in Referenz [2] auch Prismen mit dreieckigen oder quadratischen Querschnittsflächen sowie in einem Ausführungsbeispiel auch solche mit einer hexagonalen Querschnittsfläche offenbart.

Auch in der -ebenfalls bereits eingangs zitierten- Referenz [1] wird eine Hexagon-Variante als Ausführungsform von einzelnen Magnetsegmenten zum Aufbau einer Halbach-Ringanordnung beschrieben.

Die US 5 705 902 A (=Referenz [11]) beschreibt ein generisches Permanentmagnetsystem mit den eingangs definierten Merkmalskomplexen, bei welchem die Magnetsegmente in der Ringebene jeweils einen untereinander identischen, konvexen, regelmäßig oktogonalen Querschnitt aufweisen.

Auch aus dem Artikel von BAUN OLGA ET AL: "Permanent magnet system to guide superparamagnetic particles" (=Referenz [12]) sowie aus dem Artikel von BLÜMLER PETER: "Proposal for a permanent magnet system with a constant gradient mechanically adjustable in direction and strength" (=Referenz [13]) sind ähnliche Halbach-Anordnungen wie in Referenz [11] bekannt, bei denen die Flächen partiell aneinander liegen.

Zusammenfassend lässt sich feststellen, dass in der Praxis Magnetsysteme in Halbach-Konfiguration, wie sie beispielsweise für MR Apparaturen zur Anwendung kommen, häufig aus Anordnungen mehrerer einzelner permanentmagnetischer Magnetsegmente aufgebaut werden, um eine geeignete räumliche Charakteristik des magnetischen Feldes zu erzeugen. Dies wird entweder erreicht, indem der magnetische Fluss mittels magnetisch permeabler Materialien geführt wird oder indem man verschiedene Magnetisierungsrichtungen überlagert. Letzteres ist herstellungsbedingt nur durch verschiedene Orientierung der Vorzugsrichtungen der einzelnen Magnetsegmente möglich.

Gängige Realisierungen bestehen z.B. in Kreisringsegmenten von untereinander identischer Form, jedoch mit unterschiedlichen Magnetisierungsrichtungen. Diese müssen winkelrichtig aus einem gesinterten Rohteil auserodiert werden - mithin unter Inkaufnahme eines höheren Bedarfs vom teuren permanentmagnetischem Ausgangsmaterial. Dies wird durch die Verwendung von Magnetsegmenten in Form von identischen Polyeder-Prismen vermieden.

Magnetsegmente für Halbach-Magnetringe haben eine im Umlauf um den Magnetring sich jeweils ändernde Magnetisierungsrichtung. Um den Herstellprozess zu vereinfachen und zu standardisieren, ist es -wie oben erläutert- wünschenswert, immer gleichförmige Segmente herzustellen, die man bei der Montage zum Magnetring dann problemlos und unaufwändig zusammensetzen kann.

Dies alles stellt aber sowohl an Herstellung solcher Magnetsegmente für Halbach-Magnetringe als auch an die Teilelogistik hohe Anforderungen. Da die Magnetisierung eines Segments nicht von außen mit bloßem Auge erkennbar ist, besteht eine erhöhte Fehleranfälligkeit bei der Montage. Gleichzeitig ist der Herstellungsaufwand hoch, da oftmals der Einsatz von verschiedenen Segmenttypen in entsprechend voneinander abweichenden Herstellungsprozessen erforderlich ist. Wählt man eine der oben vorgeschlagenen prismatischen Polygon-Geometrien, lassen sich (angenäherte) Halbachringe mit nur einer einzigen Segmentsorte zusammensetzen. Die graduelle Variation der Magnetisierungsrichtung wird durch entsprechendes Verdrehen des Segments erreicht.

Aufgabe der Erfindung

Der vorliegenden Erfindung liegt demgegenüber die -komplexe- Aufgabe zugrunde, mit möglichst einfachen technischen Maßnahmen ein besonders kompaktes und leichtgewichtiges Permanentmagnetsystem der eingangs definierten generischen Art, insbesondere für eine MR-Vorrichtung, bereitzustellen, bei welchem die jeweils ein ringförmiges Magnetelement aufbauenden einzelnen polygonalen Magnetsegmente einerseits in einem verschlankten und automatisierbaren Verfahren besonders einfach herzustellen sind, wobei andererseits die Anforderungen an die Feldstärke und Homogenität des mit dem Permanentmagneten in Halbach-Konfigurierung zu erzeugenden Magnetfelds sicher eingehalten und optimiert werden können. Gegenüber bekannten Lösungen mit Magnetsegmenten, die einen dreieckigen, quadratischen, oder hexagonalen Querschnitt aufweisen, soll jedoch mit der Erfindung eine deutliche Verbesserung bei der Materialeffizienz sowie bei der mit dem Halbachring erzeugten magnetischen Flussdichte erzielt werden.

Kurze Beschreibung der Erfindung

Diese Aufgabe wird hinsichtlich der Magnetanordnung durch die vorliegende Erfindung auf ebenso überraschend einfache wie wirkungsvolle Weise dadurch gelöst, dass die Magnetsegmente in der Ringebene jeweils einen untereinander identischen, konvexen, regelmäßig pentagonalen oder heptagonalen Querschnitt aufweisen.
Jeder Halbachring besteht in der Regel aus einheitlichem Permanentmagnetmaterial, das allerdings bei verschiedenen Ringen unterschiedlich gewählt sein kann.
Die Erfindung beinhaltet Anordnungen von einem oder mehreren Halbachringen mit dem Ziel, ein möglichst starkes, besonders homogenes Magnetfeld in einem vordefinierten Messvolumen bei möglichst geringem Materialeinsatz, also mit hohem Füllfaktor, zu erzeugen. Ein zentrales Merkmal des erfindungsgemäßen Designs und besonders vorteilhaft ist die überaus einfache technische Umsetzung durch die Bereitstellung von jeweils untereinander identischen, prismatischen Magnetsegmenten mit konvexem, entweder regelmäßig pentagonalem oder heptagonalem Querschnitt senkrecht zur Prismenachse. Aus diesen identischen Magnetsegmenten wird dann jeweils ein ringförmiges Magnetelement in einer Halbach-Konfiguration aufgebaut.
Wie weiter unten im Detail diskutiert wird, ist dem Erfinder aufgefallen, dass diejenigen Realisierungen von Polygonvarianten, deren Querschnittsflächen zusammen einen Kreisring möglichst gut ausfüllen, in ihrer Effizienz am besten sind. Die an sich bekannte Hexagonvariante fällt allerdings überraschenderweise nicht darunter. Denkt man sich einen Innenkreis sowie einen Umkreis dazu, fällt nämlich bei näherer Betrachtung auf, dass es beim Hexagon viel Fläche gibt, die nicht von Magnetmaterial bedeckt ist. Als deutlich günstiger erweist sich eine heptagonale Querschnittsgeometrie und besonders gute Eigenschaften zeigen Prismen mit pentagonalem Querschnitt senkrecht zur Prismenachse

Bevorzugte Ausführungsformen und Weiterbildungen der Erfindung

Ganz besonders bevorzugt ist eine Klasse von Ausführungsformen der erfindungsgemäßen Magnetanordnung, bei der die magnetische Vorzugsrichtung jedes der polyedrischen Magnetsegmente jeweils in der Ringebene längs einer der Mittelsenkrechten des jeweiligen polygonalen Querschnitts verläuft.
Damit ist sichergestellt, dass das Winkelinkrement der Magnetisierungsrichtung, was durch das HALBACH Magnetisierungsschema gefordert wird, allein durch entsprechendes Verdrehen der Segmente bewerkstelligt werden kann, wobei die Segmente in der jeweiligen Montageposition sowohl formschlüssig mit den jeweiligen Nachbarsegmenten als auch winkelrichtig platziert werden können, um die HALBACH Bedingung zu erfüllen.
Weitere vorteilhafte Ausführungsformen sind dadurch gekennzeichnet, dass die Form des Querschnitts der untereinander geometrisch identischen Magnetsegmente in der Ringebene

-   entweder pentagonal ist und die Anzahl n=10 beträgt,
-   oder heptagonal ist und die Anzahl n=14 beträgt.

Bei HALBACH Magnetringen ist die erzielbare magnetische Flussdichte im Inneren proportional zum Logarithmus des Radienverhältnisses von Außen- und Innenradius des Zylinders. Die Flussdichte ist bereits durch entsprechende Wahl dieses Verhältnisses einstellbar. Bei den Polygonringen ergeben sich auf Grund der geometrischen Eigenschaften feste Radienverhältnisse und daraus zwangsläufig auch feste Multiplikatoren für die erzielbare Flussdichte. Mit zunehmender Segmentanzahl nähert sich das Radienverhältnis immer mehr dem Wert 1,0 an, der Multiplikator geht somit gegen Null. Durch entsprechende Wahl der Segmentzahl lässt sich also die Größenordnung der zu erzielenden Flussdichte vorwählen und durch Wahl der Remanenz des Magnetmaterials genau einstellen.

Eine weitere vorteilhafte Ausführungsform sieht vor, dass mehrere ringförmige Magnetelemente konzentrisch um die z-Achse angeordnet sind, wobei ein radial inneres, aus n Magnetsegmenten aufgebautes Magnetelement der ringförmigen Magnetanordnung koaxial zur z-Achse von einem radial äußeren, aus n' Magnetsegmenten aufgebauten Magnetelement umgeben ist. Eine solche radiale Stückelung kann Vorteile für die Herstellung haben. Außerdem wird beispielsweise ermöglicht, im Bereich kleinerer Radien auf hochkoerzitives Material zurückzugreifen, um den höheren Entmagnetisierungskräften Rechnung zu tragen.

Wie im vorherigen Abschnitt beschrieben, ist die erzielbare Flussdichte durch das feste Radienverhältnis der jeweiligen Polygonanordnung beschränkt. Um höhere Flussdichten zu erreichen, ist eine radiale Kaskadierung und daraus resultierende Superposition der Flussdichten mehrerer Ringe ineinander möglich. Dabei ist vor allem zu beachten, dass die zulässigen Koerzitivfelder des/der innen liegenden Rings/Ringe nicht überschritten werden.

Eine weitere bevorzugte Ausführungsform der Erfindung ist dadurch gekennzeichnet, dass mehrere ringförmige Magnetelemente in z-Richtung übereinander gestapelt angeordnet sind, indem in der Magnetanordnung mindestens zwei ringförmige Magnetelemente mit Abstand voneinander in axialer Richtung der z-Achse angeordnet sind.

Die perfekte Feldhomogenität im Inneren eines Magnetzylinders mit HALBACH Magnetisierung ist nur für den theoretischen Fall unendlicher axialer Ausdehnung gegeben. Für den Anwendungsfall mit finiter Länge des Probenvolumens kann das benötigte Grundniveau an Feldhomogenität hergestellt werden, indem die axiale Länge üblicherweise ein Vielfaches der Länge des Probevolumens beträgt, was den Forderungen nach kompakter Bauweise und effizientem Einsatz des kostenintensiven Magnetmaterials entgegensteht. Durch axiale Teilung des Einzelrings bzw. axiale Kaskadierung mehrerer Magnetringe lässt sich die Homogenität jedoch auch entlang der axialen Richtung verbessern. Um den Teilungsspalt nicht in der Zentralebene zu erhalten, wo maximale Empfindlichkeit der Homogenität in Abhängigkeit von der Größe des Trennspalts so wie etwaigem lateralen Versatz der Ringe zueinander besteht, sind Ausführungsformen mit wenigstens drei Ringen zu bevorzugen.

In den Rahmen der vorliegenden Erfindung fällt auch ein Verfahren zur Herstellung eines erfindungsgemäßen Permanentmagnetsystems der oben beschriebenen Art, umfassend folgende Schritte:

a) Bereitstellung der aus Rohmaterial in Pulverform, insbesondere Seltenerden, zu einem Amalgam gesinterten Magnetsegmente gleicher polyedrischer Geometrie und einer magnetischen Vorzugsrichtung, welche jeweils in der Ringebene längs einer der Mittelsenkrechten des jeweiligen polygonalen Querschnitts verläuft;
b) Aufmagnetisierung der Magnetsegmente in einer Aufnahmevorrichtung parallel oder antiparallel zur magnetischen Vorzugsrichtung;
c) Montage des ringförmigen Magnetelements aus n Magnetsegmenten in einer Haltestruktur.

Die hier beschriebene Vorgehensweise unterstützt eine zeiteffiziente Herstellung durch einfache, repetitive Montagezyklen.

Im Rahmen des erfindungsgemäßen Verfahrens weisen die Magnetsegmente in der Ringebene jeweils einen untereinander identischen, konvexen, regelmäßig pentagonalen oder heptagonalen Querschnitt auf.

Die Herstellung der Magnetsemente gestaltet sich mit zunehmender Kantenzahl aufwändiger. Weiterhin werden die Magnetsegmente mit zunehmender Eckenzahl immer stumpfwinkliger, wobei sich die Querschnittsfläche der Kreisform annähert. Die geometrische Einfachheit und die Möglichkeit, einen sicheren Formschluss mit entsprechenden Vorrichtungen zur Montage und Handhabung herzustellen, geht also mit zunehmender Eckenzahl wieder verloren. Die beschriebenen Varianten stellen bevorzugte Ausführungsformen unter Berücksichtigung der geometrischen Vorteile und hoher Materialeffizienz dar.

In einer weiteren bevorzugten Verfahrensvariante weist die Haltestruktur n auf die geometrische Form der Magnetsegmente passgenau abgestimmte Aussparungen zur formschlüssigen Fixierung der Magnetsegmente auf. Entsprechende Merkmale sind per se bereits bekannt aus dem Artikel von RAICH H ET AL: "Design and construction of a dipolar Halbach array with a homogeneous field from identical bar magnets: NMR Mandhalas" (=Referenz [14]).

Die Kraftwirkung derartiger Magnetanordnungen ist dahingehend gerichtet, einen Zustand niedrigster Energie zu erreichen, indem die Magnetsegmente durch Anziehungs- und Abstoßungskräfte in einen ungeordneten Zustand umgruppiert werden. Um Kräfte entsprechend aufzufangen und die Magnetsegmente gegen Bewegung zu arretieren, bietet sich unter Ausnutzung der Segmentgeometrie an, Haltestrukturen mit passgenau ausgesparten Lücken zu verwenden. Auf diese Weise ist die Endposition der zu montierenden Teile fest vorgegeben und ein unerwünschtes Lösen wird verhindert.

Vorteilhaft ist auch eine Weiterbildung dieser Verfahrensvariante, bei welcher die Aussparungen jeweils diejenigen Seitenflächen der polyedrischen Magnetsegmente offenlassen, an welchen diese die beiden ihnen benachbarten Magnetsegmente flächig berühren.

Werden die Segmente lückenlos aneinander setzt, berührt jedes Segment zwei Kanten - jeweils eine zu seinem linken und eine zu seinem rechten Nachbarn. An diesen Kanten muss die Aussparung zwangsläufig nahtlos von der einen in die nächste übergehen, da ein Steg die Segmente auf Abstand halten würde.

Eine weitere bevorzugte Verfahrensvariante zeichnet sich dadurch aus, dass die n Magnetsegmente in Montageschritt c) mittels einer, vorzugsweise automatisch betreibbaren, Greifvorrichtung sequentiell aufgenommen und in die Aussparungen der Haltestruktur eingesetzt werden.

Auf diese Weise ist die Endposition der zu montierenden Teile fest vorgegeben und ein unerwünschtes Lösen wird verhindert. Die hier beschriebene Vorgehensweise unterstützt eine zeiteffiziente Herstellung durch einfache, repetitive Montagezyklen, was die Komplexität entsprechender Montagevorrichtungen reduziert. Des Weiteren ist aber auch die höhere Arbeitssicherheit bei der Verwendung der Haltestrukturen bzw. des Greifers ein Vorteil. Der Sicherheitsaspekt spielt sowohl bei Montage als auch beim fertigen Produkt eine große Rolle. Lose Segmente können beschleunigt werden und eine Projektilwirkung auf Mensch und Gerät entfalten eventuell sogar mit Splitterbildung. Ein Lösen beziehungsweise eine freie Beweglichkeit der Magnetsegmente im Feld muss unbedingt vermieden werden.

Ebenfalls bevorzugt ist eine Weiterbildung dieser Verfahrensvariante, bei welcher die Haltestruktur und/oder die Greifvorrichtung beim sequentiellen Montagevorgang um eine Achse parallel zur z-Achse der Magnetanordnung rotiert wird.

Auf diese Weise ist die Endposition der zu montierenden Teile fest vorgegeben und Montagefehler werden vermieden. Die hier beschriebene Vorgehensweise unterstützt eine zeiteffiziente Herstellung durch einfache, repetitive Montagezyklen, was die Komplexität entsprechender Montagevorrichtungen reduziert.

Bei einer weiteren vorteilhaften Verfahrensvariante erfolgt in einem Zwischenschritt a') vor dem Aufmagnetisieren der Magnetsegmente eine äußerliche Nachbearbeitung der Flächen und/oder Kanten der polyedrischen Magnetsegmente, vorzugsweise durch Erodieren, Schleifen oder Fräsen.

Es ist sowohl möglich, die Magnetsegmente in der gewünschten Geometrie zu sintern, andererseits sind Formtoleranz und Oberflächengüte beim Nacherodieren bereits gesinterter Rohteile in der Regel besser.

Bevorzugt ist auch eine Verfahrensvariante, bei welcher in einem Zwischenschritt a") während des Sinterns der Magnetsegmente ein schwaches äußeres Magnetfeld in einer Vorzugsrichtung angelegt und die Magnetsegmente dadurch vormagnetisiert werden, wobei vorzugsweise die Vorzugsrichtung der Vormagnetisierung der Magnetsegmente dieselbe ist wie die Richtung der Aufmagnetisierung in Schritt b).

Die Vormagnetisierung der Magnetsegmente ist erforderlich, um die magnetische Vorzugsrichtung festzulegen. Das dabei aufgenommene magnetische Moment ist jedoch noch nicht permanent. Die eigentliche Aufmagnetisierung erfolgt erst später.

Bei der vorliegenden Erfindung soll ja grundsätzlich ein maximales Magnetfeld unter Verwendung von Seltenerdmaterialien erzielt werden. Diese Eigenschaften werden allerdings nur maximiert, wenn der Verfahrensschritt des Sinterns zum Amalgam im orientierten Magnetfeld geschieht. Die magnetischen Dipole lägen sonst ungeordnet und der gesamte Block wäre dann quasi nicht permanent magnetisierbar. Auf diese Weise kommen die Seltenerdmagneten auch zu maximaler Flussdichte. Im Stand der Technik wird diese Problematik nicht thematisiert. In der Regel werden die Teile aus einem Material-Block zur Herstellung von Kreiswinkelsegmenten herauserodiert. Möglicherweise ist dieser Aspekt dem einen oder anderen Fachmann geläufig, jedoch erhält er durch die Möglichkeit einer standardisierten Herstellung von untereinander gleichen polygonalen Magnetsegmenten eine ganz neue Qualität.

Eine weitere vorteilhafte Verfahrensvariante ist dadurch gekennzeichnet, dass die Form des Querschnitts der untereinander geometrisch identischen Magnetsegmente in der Ringebene entweder pentagonal ist und die Anzahl n=10 beträgt, oder heptagonal ist und die Anzahl n=14 beträgt, und dass die Aufmagnetisierung der Magnetsegmente in Schritt b) entweder in einer Richtung von einer Seitenfläche zu einer gegenüberliegenden Seitenkante des jeweils ungeradzahlig polyedrischen Magnetsegments oder in der Gegenrichtung, also von einer Seitenkante zu einer gegenüberliegenden Seitenfläche, erfolgt.

In jedem Fall ist es so, dass die Magnetisierungsrichtung parallel zur Mittelsenkrechten einer Kante des polyedrischen Magnetsegments erfolgt. Im Falle einer ungeraden Eckenzahl N des polygonalen Querschnitts verläuft diese Mittelsenkrechte eben durch die gegenüberliegende Ecke.

Diese Variante kann noch zusätzlich verbessert werden, wenn die sequentielle Aufmagnetisierung der Magnetsegmente in Schritt b) immer abwechselnd in einer Richtung oder der Gegenrichtung erfolgt. Durch diese Variation wird auch bei Realisierungen mit Segmenten ungeradzahliger Eckenzahl N sichergestellt, dass nur eine einzige Sorte von Rohsegmenten benötigt wird. Diese Option trifft allerdings nur auf ungerade Polygone zu.

Beim HALBACH Dipol hat der Magnetisierungswinkel das doppelte Winkelinkrement wie die Positionswinkel des Segments. Deshalb sind bei "6 Uhr", also 180°, bereits wieder 360° bei der Magnetisierungsrichtung angefallen, d.h. sie zeigt wieder in die gleiche Richtung wie bei "12Uhr". Beim Oktogon als Repräsentant mit gerader Eckenzahl wird quasi aus der Ausgangsposition um 2 Ecken "weitergedreht" und der Winkel passt für die nächste Position. Nord oder Südpol liegen IMMER auf einer Ecke, von daher sind die Teile völlig identisch.

Bei Repräsentanten mit ungerader Eckenzahl, ergibt sich der korrekte Magnetisierungswinkel nur, indem beim Magnetisieren entweder der Pluspol oder der Minuspol auf die Ecke gelegt wird. Ob man beim Verbauen die Reihenfolge mit Typ A und Typ B im Wechsel oder erst alle Typ A verbaut und dann die anderen in die verbliebenen Lücken, spielt in der Praxis eigentlich keine Rolle.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Anwendung finden, der Schutzumfang der Erfindung ist jedoch ausschliesslich durch die Ansprüche definiert.

Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in den Figuren und Diagrammen der Zeichnung dargestellt und wird anhand von Ausführungsbeispielen näher erläutert.

Es zeigen:

Fig.1a    einen schematischen Horizontalschnitt durch die Ringebene einer Ausführungsform der erfindungsgemäßen Magnetanordnung mit einem ringförmigen Magnetelement aufgebaut aus **n=10** untereinander identischen prismatischen Magnetsegmenten mit jeweils konvexem, regelmäßig **pentagonal**em Querschnitt senkrecht zur Prismenachse;

Fig. 1b    ein Magnetelement aufgebaut aus **zwei Sub-Ringen** mit einem radial nach außen versetzten Magnetring wie in Fig. 1a, der radial innen einen weiteren, kleineren Magnetring umfasst, welcher ebenfalls **n=10** untereinander identische prismatische Magnetsegmente mit jeweils konvexem, regelmäßig **pentagonal**em Querschnitt aufweist;

Fig. 2    einen schematischen Horizontalschnitt durch eine Ausführungsform der erfindungsgemäßen Magnetanordnung mit einem ringförmigen Magnetelement aufgebaut aus **n=14** untereinander identischen prismatischen Magnetsegmenten mit jeweils konvexem, regelmäßig **heptagonal**em Querschnitt senkrecht zur Prismenachse;

Fig. 3a    einen schematischen Horizontalschnitt durch eine nicht zur vorliegenden Erfindung gehörende Bauform einer Magnetanordnung mit einem ringförmigen Magnetelement aufgebaut aus **n=4** untereinander identischen prismatischen Magnetsegmenten mit jeweils konvexem, regelmäßig **oktogonal**em Querschnitt senkrecht zur Prismenachse;

Fig. 3b    einen schematischen Horizontalschnitt durch eine weitere nicht zur vorliegenden Erfindung gehörende Bauform einer Magnetanordnung mit einem ringförmigen Magnetelement aufgebaut aus **n=8** untereinander identischen prismatischen Magnetsegmenten mit jeweils konvexem, regelmäßig **oktogonal**em Querschnitt senkrecht zur Prismenachse;

Fig. 4    eine graphische Darstellung der **Abhängigkeit der Magnetisierung bezogen auf den Segmentwinkel** bei unterschiedlicher Anzahl n von Magnetsegmenten in einem ringförmigen Magnetelement;

Fig. 5    eine schematische Abfolge der Verfahrensschritte A1 bis A4 bei der **Herstellung von prismatischen Magnetsegmenten;**

Fig. 6    eine schematische Abfolge der Verfahrensschritte B1 bis B3 bei der **Verarbeitung von prismatischen Magnetsegmenten zu einem ringförmigen Magnetelement;**

Fig. 7    eine schematische Abfolge der Verfahrensschritte C1 bis C4 bei der **Verarbeitung von prismatischen Magnetsegmenten zweier entgegengesetzter Magnetisierungstypen** zu einem ringförmigen Magnetelement; und

Fig. 8    eine schematische Abfolge der Verfahrensschritte D1 bis D3 bei der **Magnetisierung von prismatischen Magnetsegmenten sowie dem winkelrichtigen Zusammenfügen** zu einem ringförmigen Magnetelement.

Das erfindungsgemäße Permanentmagnetsystem umfasst eine ringförmig um eine z-Achse aufgebaute **Mag-**

**netanordnung 1; 1'; 1"; 1'''; 1'''',** wie sie in der Zeichnung in verschiedenen Ausführungsformen jeweils schematisch dargestellt ist. Es findet seine Hauptanwendung als Bestandteil einer -in der Zeichnung nicht eigens gezeigten- Magnetresonanz-Apparatur mit dem Permanentmagnetsystem zur Erzeugung eines homogenen Magnetfeldes $B_0$ in Richtung senkrecht zu einer z-Achse in einem **Messvolumen 0; 0'; 0"; 0'''; 0'''',** innerhalb der ringförmigen Magnetanordnung 1; 1'; 1"; 1'''; 1'''', welche mindestens ein ringförmiges **Magnetelement 2; 2a', 2b'; 2"; 2'''; 2''''** mit magnetischem Material in einer Ringebene umfasst, das in einer Halbach-Konfiguration eine Anzahl n nebeneinander sowie jeweils mit Flächenanlage angeordnete einzelne **Magnetsegmente 3; 3a', 3b'; 3"; 3'''; 3''''** aufweist, die im Umlauf um das ringförmige Magnetelement 2; 2a', 2b'; 2"; 2'''; 2'''' gemäß den Regeln einer Halbach-Anordnung sich ändernde Magnetisierungsrichtungen haben, die zusammen ein magnetisches Dipolfeld in der Ringebene der ringförmigen Magnetanordnung 1; 1'; 1"; 1'''; 1'''' "" erzeugen, und die untereinander gleiche polyedrische Geometrie und in der Ringebene jeweils einen identischen, konvexen, regelmäßig polygonalen Querschnitt aufweisen.

Die vorliegende Erfindung schlägt für die Schaffung von Halbach-Ringen vor, dass die Magnetsegmente 3; 3a', 3b'; 3"; 3'''; 3'''' in der Ringebene jeweils einen untereinander identischen, konvexen, regelmäßig pentagonalen oder heptagonalen Querschnitt aufweisen.

Ein Verfahren zur Herstellung eines erfindungsgemäßen Permanentmagnetsystems umfasst folgende Schritte:

a) Bereitstellung der aus Rohmaterial in Pulverform, insbesondere Seltenerden, zu einem Amalgam gesinterten Magnetsegmente 3; 3a', 3b'; 3"; 3'''; 3'''' gleicher polyedrischer Geometrie und einer magnetischen Vorzugsrichtung, jeweils in der Ringebene längs einer der Mittelsenkrechten des jeweiligen polygonalen Querschnitts verläuft;

b) Aufmagnetisierung der Magnetsegmente 3; 3a', 3b'; 3"; 3'''; 3'''' in einer **Aufnahmevorrichtung AV** parallel oder antiparallel zur magnetischen Vorzugsrichtung;

c) Montage des ringförmigen Magnetelements 2; 2a', 2b'; 2"; 2'''; 2'''' aus n Magnetsegmenten 3; 3a', 3b'; 3"; 3'''; 3'''' in einer **Haltestruktur HS.**

Die Haltestruktur HS weist n auf die geometrische Form der Magnetsegmente 3; 3a', 3b'; 3"; 3'''; 3'''' passgenau abgestimmte **Aussparungen AS** zur formschlüssigen Fixierung der Magnetsegmente 3; 3a', 3b'; 3"; 3'''; 3'''' auf. Die n Magnetsegmente 3; 3a', 3b'; 3"; 3'''; 3'''' werden in Montageschritt c) mittels einer, vorzugsweise automatisch betreibbaren, **Greifvorrichtung GV** sequentiell aufgenommen und in die Aussparungen AS der Haltestruktur HS eingesetzt. Die Haltestruktur HS und/oder die Greifvorrichtung GV kann beim sequentiellen Montagevorgang um eine Achse parallel zur z-Achse der Magnetanordnung 1; 1'; 1"; 1'''; 1'''' rotiert werden.

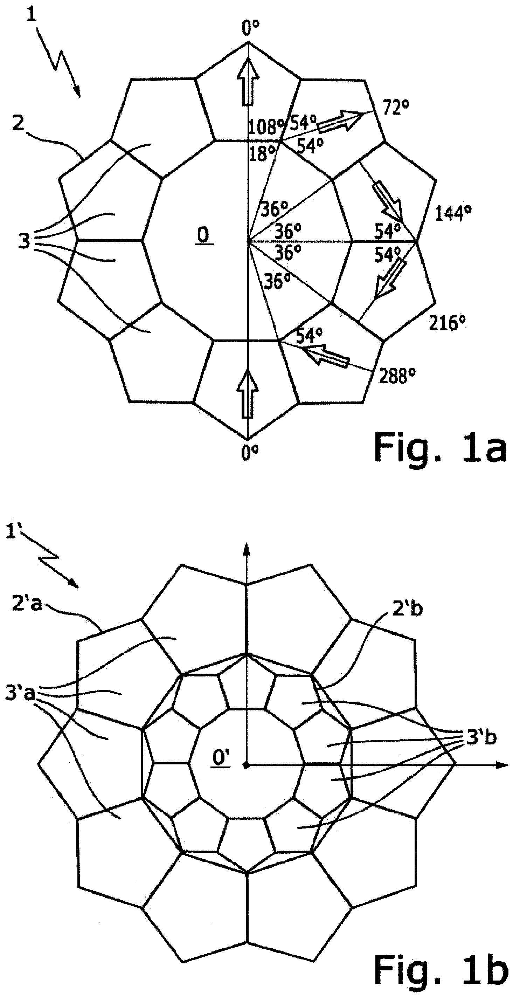

In **Fig. 1a** ist in einem schematischen Horizontalschnitt durch die Ringebene eine Ausführungsform der erfindungsgemäßen Magnetanordnung 1 mit einem ringförmig um ein Messvolumen 0 angeordneten Magnetelement 2 zu erkennen, welches aufgebaut ist aus n=10 untereinander identischen prismatischen Magnetsegmenten 3 mit jeweils konvexem, regelmäßig pentagonalem Querschnitt senkrecht zur Prismenachse. Die Magnetisierungsrichtung der ringförmig in HALBACH-Anordnung gruppierten Magnetsegmente 3 ist in der rechten Bildhälfte jeweils durch einen Pfeil angedeutet.

Bei diesem auf zehn Pentagonen basierenden Halbach-Dipolring ergibt sich der Scheitelwinkel zu 360°/10= 36°. Der Innenwinkel zu 180°*(n-2)/n=108°. Beim Dipol muss die Magnetisierung mit dem doppelten Winkelinkrement erfolgen, also 72°. Anhand der geltenden Winkelbeziehungen lässt sich nachvollziehen, dass die Magnetisierungsachse bei allen Magnetsegmenten 3 stets auf einer der Mittelsenkrechten liegt. Der Nord- bzw. Südpol liegt bei Polygonrealisierungen mit ungeradem n im Wechsel auf einer Spitze oder mittig auf einer Kante.

Da beim Sintervorgang jedoch ausschließlich die Magnetisierungsachse eingeprägt wird, sind die unmagnetisierten Segmente herstellungsseitig völlig identisch. Die Polarität wird erst beim Magnetisieren festgelegt, sodass sich daraus zwei Varianten magnetisierter Segmente ergeben.

Weiterhin ist auch eine Fortsetzung des erfindungsgemäßen Konzepts auf koaxial ineinandergreifende Ringanordnungen denkbar, womit auch höhere Flussdichten realisierbar sind. Allerdings gibt es nur wenige Parkettierungen, die eine lückenlose Fortsetzung in radialer Richtung erlauben.

Das erfindungsgemäße Permanentmagnetsystem kann daher auch mehrere ringförmige Magnetelemente 2a'; 2b' aufweisen. Bei der in **Fig. 1b** gezeigten Ausführungsform einer Magnetanordnung 1' sind die aus Magnetsegmenten 3a'; 3b' aufgebauten ringförmige Magnetelemente 2a'; 2b' konzentrisch um die z-Achse im Zentrum des Messvolumens 0' angeordnet.

Da die Stärke des entmagnetisierenden Feldes im Innenbereich höher ist, bietet es sich außerdem an, den Innenring aus hochkoerzitivem Material herzustellen.

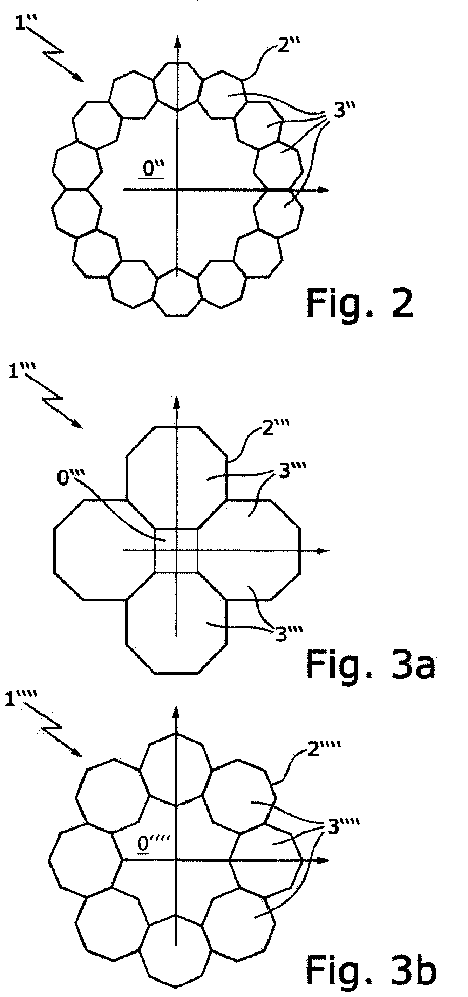

**Fig. 2** zeigt eine Magnetanordnung 1" mit einem ringförmig um ein Messvolumen 0" angeordneten Magnetelement 2" aufgebaut aus n=14 -wiederum untereinander identischen- prismatischen Magnetsegmenten 3" mit jeweils regelmäßig heptagonalem Querschnitt senkrecht zur Prismenachse.

In **Fig. 3a** ist eine Bauform einer Magnetanordnung 1''' mit einem ringförmig um ein Messvolumen 0''' angeordneten Magnetelement 2''' aufgebaut aus n=4 untereinander identischen prismatischen Magnetsegmenten 3''' mit jeweils oktogonalem Querschnitt senkrecht zur Prismenachse dargestellt.

**Fig. 3b** zeigt eine Magnetanordnung 1'''' mit einem ringförmig um ein Messvolumen 0'''' angeordneten Magnetelement 2'''' aufgebaut aus n=8 prismatischen Magnetsegmenten 3'''' mit jeweils oktogonalem Querschnitt.

Die Magnetisierungsachse wird für die gewählte Polygongeometrie festgelegt. Es handelt sich um regelmäßige konvexe Polygontypen, d.h. sie haben gleiche Innenwinkel <180° und gleiche Seitenlängen. Aus der sich ergebenden Anzahl der für einen geschlossenen Ring erforderlichen Einzelsegmente, ergibt sich auch das Winkelinkrement für die Magnetisierung. Der Magnetisierungsvektor dreht im Winkelbereich der Hälfte der Segmente um 180° (Halbach Dipol).

Im Folgenden sollen -vom Erfinder gefundene und aufdeckte- allgemeine Prinzipien bei der Auswahl der optimalen Geometrie von prismatischen Magnetsegmenten in einer HALBACH-Anordnung vorgestellt werden:

**1. HALBACH Dipolmagnetanordnung basierend auf regulären Polygonen**

Bedingungen:

- Nur ein einziger Polygontyp soll verwendet werden.
- Die Anzahl der Polygone soll geradzahlig sein (um Spiegelsymmetrie bzgl. wenigstens einer Achse zu erhalten).
- Benachbarte Polygone berühren sich entlang einer Kante.
- Der Inkreis wird von jedem Polygon berührt, die Zentren aller Polygone liegen auf demselben Kreis um das Zentrum.

Folgerungen:

- Die *Berührkanten* zu den zwei benachbarten Polygonen schneiden sich in ihrer Verlängerung im Zentrum und definieren den Mittelpunktswinkel Y.
- Zwischen den zum Mittelpunkt hin zeigenden Endpunkten der Berührkanten liegt mindestens eine *Innenkante,* die den Inkreis berührt.
- Zwischen den vom Mittelpunkt weg zeigenden Endpunkten der Berührkanten liegt bei jedem Polygon mindestens eine *Außenkante* mehr, als es Innenkanten gibt.
- Die Polygone müssen mindestens 5 Kanten aufweisen (Pentagone: 2 Berührkanten, eine Innenkante, zwei Außenkanten).
- Inkreisradius, Außenkreisradius stehen für jede der Anordnungen in festem Verhältnis zur Kantenlänge und damit auch zueinander.
- Mit steigender Eckenzahl n verringert sich der Anteil der Länge am Umfang, wo benachbarte Polygone sich berühren.

Mit steigender Eckenzahl n erhält man:

- Die erste Lösung basiert auf 10 Pentagonen, mit einem (regulären) Dekagon (10-Eck) im Innern.
- Die zweite Lösung basiert auf 6 Hexagonen, mit einem (kongruenten) Hexagon im Innern.
- Die dritte Lösung basiert auf 14 Heptagonen, mit einem (regulären) Tetradekagon im Innern.
- Die vierte Lösung basiert auf 4 Oktogonen, mit einem Quadrat im Innern.
- [...]

Um die einzelnen Anordnungen hinsichtlich Materialbedarf und Flussdichte bewerten zu können, werden zwei Vergleichsanordnungen definiert:

H   Ein idealer HALBACH Ring (Magnetisierungsrichtung variiert kontinuierlich mit dem doppelten Polarwinkel), wobei der Innenradius Rin gleich dem Inkreisradius der Polygonanordnung ist und der Außenradius für gleiche Flussdichte B0 angepasst wird.

S   Ein realer HALBACH Ring bestehend aus N Kreisringsegmenten (Magnetisierungsrichtung variiert diskret mit 720°/n), wobei der Innenradius Rin gleich dem Inkreisradius der Polygonanordnung ist und der Außenradius für gleiche Flussdichte B0 angepasst wird.

Als Vergleichsgrößen werden Inkreisradius Rin, Umkreisradius Rout, Flächeninhalt An und Kantenlänge a herangezogen, sowie daraus abgeleitete Größen.

Es wird davon ausgegangen, dass eine möglichst kleine Zahl an Segmenten zu bevorzugen ist. Die Diskretisierung der Magnetisierung bewirkt beim segmentierten HALBACH Ring eine Reduzierung der Flussdichte bezogen auf den idealen HALBACH Ring.

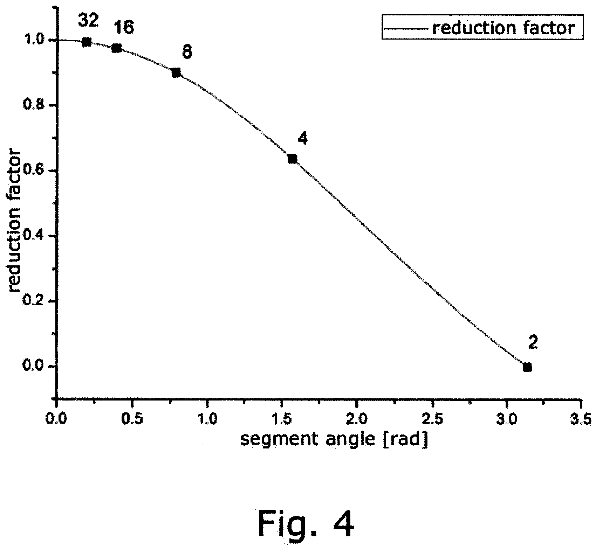

Aus der in **Fig. 4** dargestellten Abhängigkeit der Magnetisierung bezogen auf den Segmentwinkel bei unterschiedlicher Anzahl n von Magnetsegmenten in einem ringförmigen Magnetelement lässt sich bereits schließen, dass auch die Ringanordnungen mit weniger als 6 Segmenten tendenziell eher zu ineffizient sein dürften.

**1.1 Pentagon (n=5, N=10)**

Die Innenwinkel betragen $\alpha$=108°. Verlängert man eine Kante und die übernächste Kante, erhält man einen Schnittpunkt, der sich als Mittelpunkt der Anordnung herausstellt. Über Nebenwinkelsatz und Innenwinkelsatz, lässt sich der Mittelpunktwinkel $\gamma$ = 36° bestimmen, entsprechend einer Ringanordnung von zehn Pentagonen. Für die Annäherung an einen Dipolring mit HALBACH Magnetisierung muss die Magnetisierungsrichtung demnach in 5 Schritten diskretisiert werden:

$$\beta = \frac{720°}{10} = 72°$$

Der Innenbereich hat die Gestalt eines regelmäßigen Zehnecks (Dekagon) mit gleichen Kantenlänge a5. Da der Bohrungsradius Rin eine Kenngröße für den nutzbaren Innenraum darstellt, werden alle Größen soweit möglich in Abhängigkeit vom Bohrungsradius Rin dargestellt. Für das Dekagon erhält man:

$$R_{in} = \frac{a_5}{2}\sqrt{5 + 2\sqrt{5}} \rightarrow a_5 = \frac{2R_{in}}{\sqrt{5 + 2\sqrt{5}}}$$

Der Umkreisradius ergibt sich als Summe des Inkreisradius Rin und der Höhe h5 im Pentagon:

$$R_{out} = R_{in} + h_5 = \frac{a_5}{2}\sqrt{5 + 2\sqrt{5}} + \frac{a_5}{2}\sqrt{5 + 2\sqrt{5}} = 2R_{in}$$

Für die Flächen eines Pentagon sowie der gesamten Ringanordnung gilt:

$$A_5 = \frac{\sqrt{5}}{\sqrt{5 + 2\sqrt{5}}}R_{in}{}^2$$

$$A_{5,10} = \frac{10\sqrt{5}}{\sqrt{5 + 2\sqrt{5}}}R_{in}{}^2 \approx 7{,}265R_{in}{}^2$$

Die Kantenlänge ist an den Innenradius gekoppelt, Rin und Rout stehen in einem festen Verhältnis zu einander. Diese Eigenschaften sind grundlegend und damit bei allen vergleichbaren Anordnungen gegeben.
Bekanntermaßen ist die magnetische Flussdichte eines HALBACH Dipolrings proportional zum Logarithmus des Verhältnisses von Außen- und Innenradius. Das fest vorgegebene Radienverhältnis bei der Pentagonanordnung lässt mutmaßen, dass es damit auch die Flussdichte festgelegt ist.
Als ein Maß für die Packungsdichte bzw. Flächenausnutzung kann der Anteil der tatsächlich von den Pentagonen belegt wird an der Gesamtfläche des aus Inkreis und Umkreis gebildeten Kreisrings benutzt werden.

$$\varepsilon_A = \frac{A_{5,10}}{A_{out} - A_{in}} = \frac{\frac{10\sqrt{5}}{\sqrt{5 + 2\sqrt{5}}}R_{in}{}^2}{\pi\left(R_{out}{}^2 - R_{in}{}^2\right)} = \frac{\frac{10\sqrt{5}}{\sqrt{5 + 2\sqrt{5}}}R_{in}{}^2}{\pi\left(4R_{in}{}^2 - R_{in}{}^2\right)} = \frac{10\sqrt{5}}{3\pi\sqrt{5 + 2\sqrt{5}}} \approx 77{,}1\%$$

Die magnetische Flussdichte dieser Anordnung wird mittels Simulation bestimmt, wobei Br die Remanenzflussdichte des verwendeten Materials ($\mu$rel=1,05 angenommen) darstellt:

$$B_{5,10} \approx 0{,}53B_r$$

Um die Effizienz dieser Anordnung zu beurteilen wird ein idealer HALBACH Dipolring mit gleicher Flussdichte ausgelegt:

$$0,53 = \frac{B_H}{B_r} = \ln\frac{R_{H,out}}{R_{H,in}} \to R_{H,out} = 1,71 R_{H,in}$$

Die Fläche und damit der Materialbedarf ergibt sich als Kreisring:

$$A_H = \pi(1,71^2 - 1)R_{H,in}{}^2 \approx 6,045 R_{in}{}^2$$

Im Vergleich mit einer idealen HALBACH Anordnung wird etwa 20,2% mehr Material benötigt.
Mittels Simulation wird ein aus 10 Segmenten zusammengesetzter HALBACH Dipolring mit gleicher Flussdichte ausgelegt:

$$R_{S,out} = 1,8 R_{S,in}$$

Die Fläche und damit der Materialbedarf ergibt sich als Kreisring:

$$A_S = \pi(1,8^2 - 1)R_{S,in}{}^2 \approx 7,037 R_{in}{}^2$$

Im Vergleich mit einer segmentierten HALBACH Anordnung wird etwa 2% mehr Material benötigt.

### 1.2 Hexagon (n=6, N=6)

Die Innenwinkel betragen $\alpha$=120°. Verlängert man eine Kante und die übernächste Kante, erhält man einen Schnittpunkt, der sich als Mittelpunkt der Anordnung herausstellt. Über Nebenwinkelsatz und Innenwinkelsatz, lässt sich der Mittelpunktwinkel $\gamma$ = 60° bestimmen, entsprechend einer Ringanordnung von sechs Hexagonen. (Diese Anordnung ist als eine der sog. *Platonischen Parkettierungen* der Ebene bekannt.) Für die Annäherung an einen Dipolring mit HALBACH Magnetisierung muss die Magnetisierungsrichtung demnach in 3 Schritten diskretisiert werden:

$$\beta = \frac{360°}{3} = 120°$$

Der Innenbereich hat die Gestalt eines kongruenten Sechsecks, alle Sechsecke haben die Kantenlänge a6. Für das Hexagon erhält man:

$$R_{in} = \frac{d_6}{2} = h_6 = \frac{a_6}{2}\sqrt{3} \to a_6 = \frac{2R_{in}}{\sqrt{3}}$$

Der Umkreisradius ergibt sich als Hypotenuse des Dreiecks welches aus a6/2 und h6 gebildet wird:

$$R_{out} = \sqrt{\left(\frac{a_6}{2}\right)^2 + (3R_{in})^2} = \sqrt{\frac{1}{3}R_{in}{}^2 + 9R_{in}{}^2} = R_{in}\sqrt{\frac{28}{3}} \approx 3,055 R_{in}$$

Für die Flächen eines Hexagons sowie der gesamten Ringanordnung gilt:

$$A_6 = 2\sqrt{3}R_{in}{}^2$$

$$A_{6,6} = 12\sqrt{3}R_{in}{}^2 \approx 20,785 R_{in}{}^2$$

Als ein Maß für die Packungsdichte bzw. Flächenausnutzung kann der Anteil der tatsächlich von den Hexagonen belegt wird an der Gesamtfläche des aus Inkreis und Umkreis gebildeten Kreisrings benutzt werden.

$$\varepsilon_A = \frac{A_{6,6}}{A_{out} - A_{in}} = \frac{12\sqrt{3}R_{in}^2}{\pi\left(R_{out}^2 - R_{in}^2\right)} = \frac{12\sqrt{3}}{\pi\left(\frac{28}{3} - 1\right)} \approx 79{,}4\%$$

Die magnetische Flussdichte dieser Anordnung wird mittels Simulation bestimmt, wobei Br die Remanenzflussdichte des verwendeten Materials ($\mu$rel=1,05 angenommen) darstellt:

$$B_{6,6} \approx 0{,}8B_r$$

Um die Effizienz dieser Anordnung zu beurteilen wird ein idealer HALBACH Dipolring mit gleicher Flussdichte ausgelegt:

$$0{,}8 = \frac{B_H}{B_r} = \ln\frac{R_{H,out}}{R_{H,in}} \rightarrow R_{H,out} = 2{,}23R_{H,in}$$

Die Fläche und damit der Materialbedarf ergibt sich als Kreisring:

$$A_H = \pi(2{,}23^2 - 1)R_{H,in}^2 \approx 12{,}481R_{in}^2$$

Im Vergleich mit einer idealen HALBACH Anordnung wird etwa 67% mehr Material benötigt.
Mittels Simulation wird ein aus 6 Segmenten zusammengesetzter HALBACH Dipolring mit gleicher Flussdichte ausgelegt:

$$R_{S,out} = 2{,}69R_{S,in}$$

Die Fläche und damit der Materialbedarf ergibt sich als Kreisring:

$$A_S = \pi(2{,}69^2 - 1)R_{S,in}^2 \approx 19{,}659R_{in}^2$$

Im Vergleich mit einer segmentierten HALBACH Anordnung wird etwa 6% mehr Material benötigt.
Der dominierende Effekt ist hierbei die grobe Diskretisierung. (Materialzunahme um über 50% nur durch Übergang von kontinuierlicher zu diskreter Magnetisierung.)

### 1.3 Heptagon (n=7, N=14)

Die Innenwinkel betragen $\alpha$=900°/7≈128,57°. Von den insgesamt 7 Kanten ergeben sich 2 Berührkanten, sowie 3 Außenkanten und 2 Innenkanten. Verlängert man eine Kante und die drittnächste Kante, erhält man einen Schnittpunkt, der sich als Mittelpunkt der Anordnung herausstellt. Über Nebenwinkelsatz und Innenwinkelsatz, lässt sich der Mittelpunktwinkel $\gamma$=3$\alpha$-360°≈25,71° bestimmen, entsprechend einer Ringanordnung von 14 Heptagonen. Für die Annäherung an einen Dipolring mit HALBACH Magnetisierung muss die Magnetisierungsrichtung demnach in 7 Schritten diskretisiert werden:

$$\beta = \frac{360°}{7} \approx 51{,}43°$$

$$\gamma = \frac{\beta}{2} = \frac{360°}{14} \approx 25{,}71°$$

Der Innenbereich hat die Gestalt eines konkaven 28-Ecks mit der Kantenlänge a7. Da der Bohrungsradius Rin eine Kenngröße für den nutzbaren Innenraum darstellt, werden alle Größen soweit möglich in Abhängigkeit vom Bohrungsradius Rin dargestellt. Der Inkreisradius lässt sich mit dem Sinussatz bestimmen:

$$\frac{a_7}{\sin\left(\frac{\gamma}{2}\right)} = \frac{R_{in}}{\sin(180° - \alpha)} \rightarrow a_7 = R_{in}\frac{\sin\left(\frac{\gamma}{2}\right)}{\sin\beta} \approx 0{,}285R_{in}$$

$$h_7 = \frac{a_7}{2\tan\left(\frac{\gamma}{2}\right)}$$

Der Umkreisradius ergibt sich als Summe des Inkreisradius und dem Durchmesser des Umkreises vom Heptagon:

$$R_{out} = \sqrt{\left(\frac{a_7}{2}\right)^2 + (h_7 + R_{in})^2} \approx 1{,}63R_{in}$$

Für die Flächen eines Heptagons sowie der gesamten Ringanordnung gilt:

$$A_7 = \frac{7a_7{}^2}{4\tan\gamma} = 7R_{in}{}^2\frac{\left(\frac{\sin\left(\frac{\gamma}{2}\right)}{\sin\beta}\right)^2}{4\tan\gamma}$$

$$A_{7,14} = 98R_{in}{}^2\frac{\left(\frac{\sin\left(\frac{\gamma}{2}\right)}{\sin(180° - \alpha)}\right)^2}{4\tan\gamma} \approx 4{,}121R_{in}{}^2$$

Als ein Maß für die Packungsdichte bzw. Flächenausnutzung kann der Anteil der tatsächlich von den Pentagonen belegt wird an der Gesamtfläche des aus Inkreis und Umkreis gebildeten Kreisrings benutzt werden.

$$\varepsilon_A = \frac{A_{7,14}}{A_{out} - A_{in}} \approx 79{,}2\%$$

Die magnetische Flussdichte dieser Anordnung wird mittels Simulation bestimmt, wobei Br die Remanenzflussdichte des verwendeten Materials ($\mu$rel=1,05 angenommen) darstellt:

$$B_{7,14} \approx 0{,}36B_r$$

Um die Effizienz dieser Anordnung zu beurteilen wird ein idealer HALBACH Dipolring mit gleicher Flussdichte ausgelegt:

$$0{,}363 = \frac{B_H}{B_r} = \ln\frac{R_{H,out}}{R_{H,in}} \rightarrow R_{H,out} = 1{,}438R_{H,in}$$

Die Fläche und damit der Materialbedarf ergibt sich als Kreisring:

$$A_H = \pi(1{,}438^2 - 1)R_{H,in}^{\;2} \approx 3{,}355R_{in}^{\;2}$$

Im Vergleich mit einer idealen HALBACH Anordnung wird etwa 23% mehr Material benötigt.

Mittels Simulation wird ein aus 14 Segmenten zusammengesetzter HALBACH Dipolring mit gleicher Flussdichte ausgelegt:

$$R_{S,out} = 1{,}473R_{S,in}$$

Die Fläche und damit der Materialbedarf ergibt sich als Kreisring:

$$A_S = \pi(1{,}473^2 - 1)R_{S,in}^{\;2} \approx 3{,}67R_{in}^{\;2}$$

Im Vergleich mit einer segmentierten HALBACH Anordnung wird etwa 12% mehr Material benötigt.

### 1.4 Oktogon (n=8, N=8)

Die Innenwinkel betragen $\alpha$=135°. Von den insgesamt 8 Kanten ergeben sich 2 Berührkanten, sowie 4 Außenkanten und 2 Innenkanten. Verlängert man eine Kante und die drittnächste Kante, erhält man einen Schnittpunkt, der sich als Mittelpunkt der Anordnung herausstellt. Über Nebenwinkelsatz und Innenwinkelsatz, lässt sich der Mittelpunktwinkel $\gamma$ =45° bestimmen, entsprechend einer Ringanordnung von 8 Oktogonen. Für die Annäherung an einen Dipolring mit HALBACH Magnetisierung muss die Magnetisierungsrichtung demnach in 4 Schritten diskretisiert werden:

$$\beta = \frac{360°}{4} \approx 90°$$

Der Innenbereich hat die Gestalt eines regelmäßigen Sechzehnecks, alle Oktogone haben die Kantenlänge a8. Für das Oktogon erhält man:

$$\sin\left(\frac{\gamma}{2}\right) = \frac{a_8}{\sqrt{2}R_{in}} \rightarrow a_8 = \sqrt{2}R_{in}\sin\left(\frac{\gamma}{2}\right)$$

Der Umkreisradius ergibt sich als Summe des Inkreisradius und dem Durchmesser des Umkreises vom Oktogon:

$$R_{out} = R_{in} + d_8 = R_{in} + \frac{a_8}{\sin\left(\frac{\gamma}{2}\right)} = R_{in} + \frac{\sqrt{2}R_{in}\sin\left(\frac{\gamma}{2}\right)}{\sin\left(\frac{\gamma}{2}\right)} = R_{in}\left(1 + \sqrt{2}\right) \approx 2{,}41R_{in}$$

Für die Flächen eines Oktogons sowie der gesamten Ringanordnung gilt:

$$A_8 = 2\left(1 + \sqrt{2}\right)a_8^2 = 4\left(1 + \sqrt{2}\right)\left(\sin\left(\frac{\gamma}{2}\right)\right)^2 R_{in}^{\;2} = \sqrt{2}R_{in}^{\;2} \approx 1{,}41R_{in}^{\;2}$$

$$A_{8,8} = 8\sqrt{2}R_{in}^{\;2} \approx 11{,}31R_{in}^{\;2}$$

Als ein Maß für die Packungsdichte bzw. Flächenausnutzung kann der Anteil der tatsächlich von den Oktogonen belegt wird an der Gesamtfläche des aus Inkreis und Umkreis gebildeten Kreisrings benutzt werden.

$$\varepsilon_A = \frac{A_{8,8}}{A_{out} - A_{in}} = \frac{8\sqrt{2}R_{in}^{\;2}}{\pi\left(R_{out}^{\;2} - R_{in}^{\;2}\right)} = \frac{4\sqrt{2}}{\pi\left(1 + \sqrt{2}\right)} \approx 74{,}6\%$$

Die magnetische Flussdichte dieser Anordnung wird mittels Simulation bestimmt, wobei Br die Remanenzflussdichte des verwendeten Materials ($\mu$rel=1,05 angenommen) darstellt:

$$B_{8,8} \approx 0{,}6 B_r$$

Um die Effizienz dieser Anordnung zu beurteilen wird ein idealer HALBACH Dipolring mit gleicher Flussdichte ausgelegt:

$$0{,}602 = \frac{B_H}{B_r} = \ln \frac{R_{H,out}}{R_{H,in}} \rightarrow R_{H,out} = 1{,}826 R_{H,in}$$

Die Fläche und damit der Materialbedarf ergibt sich als Kreisring:

$$A_H = \pi(1{,}826^2 - 1) R_{H,in}{}^2 \approx 7{,}331 R_{in}{}^2$$

Im Vergleich mit einer idealen HALBACH Anordnung wird etwa 54% mehr Material benötigt.
Mittels Simulation wird ein aus 8 Segmenten zusammengesetzter HALBACH Dipolring mit gleicher Flussdichte ausgelegt:

$$R_{S,out} = 1{,}985 R_{S,in}$$

Die Fläche und damit der Materialbedarf ergibt sich als Kreisring:

$$A_S = \pi(1{,}473^2 - 1) R_{S,in}{}^2 \approx 9{,}237 R_{in}{}^2$$

Im Vergleich mit einer segmentierten HALBACH Anordnung wird etwa 22% mehr Material benötigt.

### 1.5 Zusammenfassung

|                                    | 5,10  | 6,6   | 7,14  | 8,8   |
| ---------------------------------- | ----- | ----- | ----- | ----- |
| **B0/Br**                          | 0,53  | 0,8   | 0,36  | 0,6   |
| **Ra/Ri**                          | 2,0   | 3,06  | 1,63  | 2,41  |
| **Mat.Effizienz vs ideal. HALBACH**| -20%  | -67%  | -23%  | -54%  |
| **Mat.Effizienz vs segm. HALBACH** | -2%   | -6%   | -12%  | -22%  |

Die Varianten 6,6 und 8,8 stechen wie erwartet durch schlechte Materialeffizienz gemessen am idealen Halbachmagneten auf, was auf die grobe Diskretisierung der Magnetisierungsrichtung zurückzuführen ist.

Die Variante 5,10 erzielt die besten Werte.

Die aufgeführten B0/Br stellen Obergrenzen dar. Durch Einführung von "Sollspalten" kann B0 zusätzlich "eingestellt" werden.
Die beschriebenen Anordnungen wurden als 2D Strukturen simuliert, d.h. unter der Prämisse unendlicher räumlicher Ausdehnung entlang der longitudinalen Koordinate. Irreversible Entmagnetisierungseffekte durch Überschreiten der maximal zulässigen Koerzitivfelder wurden nicht berücksichtigt.

### 2. Erweiterungen zur Erreichung höherer Flussdichten oder Verbesserung der Materialeffizienz

Die bisher oben beschriebenen Anordnungen bestanden ausschließlich aus einer einzigen Ringstruktur, welche ausschließlich mit einer einzigen Polygonsorte aufgebaut war.

### 2.1 Kombination zweier Pentagon-Ringe

Eine Halbach-Anordnung mit zwei radial ineinander verschachtelten ringförmigen Magnetelementen 2a'; 2b' aufgebaut aus pentagonalen Magnetsegmenten 3a'; 3b' ist in Fig. 1b gezeigt.

Die Magnetisierungsachse der äußeren Pentagonsegmente verläuft parallel zu einer Seitenkante, die Magnetisierungsachse der inneren Pentagonsegmente verläuft senkrecht zu einer Seitenkante. Kantenlänge b5 der äußeren Pentagonsegmente beträgt:

$$b_5 = 2a_5 \cos 18° = \frac{4\cos 18°}{\sqrt{5 + 2\sqrt{5}}} R_{in} \approx 1{,}236\, R_{in}$$

Der Umkreisradius der neuen Anordnung beträgt:

$$R_{20} = 2\, R_{in} \cos 18° + \frac{b_5}{2}\sqrt{5 + 2\sqrt{5}} = 2R_{in}\cos 18° + 2R_{in}\cos 18° = 4R_{in}\cos 18°$$

$$\approx 3{,}804\, R_{in}$$

Für die Fläche der gesamten Ringanordnung gilt:

$$A_{5,20} = \frac{10\sqrt{5}}{\sqrt{5 + 2\sqrt{5}}} R_{in}^{\,2} + \frac{40\sqrt{5}(\cos 18°)^2}{\sqrt{5 + 2\sqrt{5}}} R_{in}^{\,2} \approx 33{,}552 R_{in}^{\,2}$$

Als ein Maß für die Packungsdichte bzw. Flächenausnutzung kann der Anteil der tatsächlich von den Pentagonen belegt wird an der Gesamtfläche des aus Inkreis und Umkreis gebildeten Kreisrings benutzt werden

$$\varepsilon_A = \frac{A_{5,20}}{A_{out} - A_{in}} = \frac{\dfrac{10\sqrt{5}}{\sqrt{5 + 2\sqrt{5}}} R_{in}^{\,2} + \dfrac{40\sqrt{5}(\cos 18°)^2}{\sqrt{5 + 2\sqrt{5}}} R_{in}^{\,2}}{\pi\!\left(R_{20}^{\,2} - R_{in}^{\,2}\right)} = \frac{\dfrac{(10 + 40(\cos 18°)^2)\sqrt{5}}{\sqrt{5 + 2\sqrt{5}}}}{\pi(16(\cos 18°)^2 - 1)}$$

$$\approx 79{,}3\%$$

Die Ausnutzung der Fläche hat sich leicht verbessert, da der zweite Pentagonring durch den Winkelversatz von 18° einen Teil der alten Umkreisfläche bedeckt. Aus den Beziehungen in Abschnitt 1 folgt gemäß Superposition, dass die Flussdichte einer solchen Anordnung gerade dem Doppelten entspricht.

$$B_{5,20} \approx 1{,}06 B_r$$

Um die Effizienz dieser Anordnung zu beurteilen wird ein idealer HALBACH Dipolring mit gleicher Flussdichte ausgelegt:

$$1{,}06 = \frac{B_H}{B_r} = \ln\frac{R_{H,out}}{R_{H,in}} \rightarrow R_{H,out} = 2{,}87 R_{H,in}$$

Die Fläche und damit der Materialbedarf ergibt sich als Kreisring:

$$A_H = \pi(2{,}87^2 - 1)R_{H,in}^{\,2} \approx 23{,}031 R_{in}^{\,2}$$

Im Vergleich mit einer idealen HALBACH Anordnung wird etwa 45,7% mehr Material benötigt.

Mittels Simulation wird ein aus 10 Segmenten zusammengesetzter HALBACH Dipolring mit gleicher Flussdichte ausgelegt:

$$R_{S,out} = 3{,}195 R_{S,in}$$

Die Fläche und damit der Materialbedarf ergibt sich als Kreisring:

$$A_S = \pi(3{,}195^2 - 1) R_{S,in}{}^2 \approx 28{,}928 R_{in}{}^2$$

Im Vergleich mit einer segmentierten HALBACH Anordnung wird etwa 16% mehr Material benötigt.

Wenn Effizienz besonders hohe Priorität hat, ist dieser Aufbau allerdings unter Umständen weniger geeignet.

### 3. Weitere Überlegungen zur Wahl geeigneter Segmentgeometrien

Die bisher angestellten Überlegungen zielen darauf ab, die magnetischen Vorzüge eines idealen 2D Halbach-Magnetrings zu erhalten, wobei die praktische Ausführung so weit wie möglich vereinfacht werden soll, um den Herstellungsaufwand einer segmentierten Ausführung zu reduzieren. (Siehe dazu auch noch einmal die Randbedingungen unter obigem Abschnitt 1.) Dies führt zu der Aufgabe, einen Kreisring so gut wie möglich, mit regulären Polygonen zu bedecken, um eine möglichst hohe Flächeneffizienz zu erhalten. Für die gesamte Ebene sind einige solche "Parkettierungen" bekannt, wie z.B. Quadrate und reguläre Hexagone, die die Ebene lückenlos parkettieren. Von diesen lassen sich unter "Weglassen" des Elements in der Mitte einfache Ringe erstellen.

Derartige Realisierungen sind bekannt, füllen jedoch einen Kreisring bestehend aus dem Inkreis und dem Umkreis schlecht aus, was im Vergleich zu anderen Realisierungen zu einer schlechten Effizienz führt. (Siehe dazu auch noch einmal die Tabelle im Abschnitt 1.5.) Im ersten Fall wird die Randbedingung gemeinsamer Kanten nicht berücksichtigt.

Ein weiterer Nachteil der o.g. Realisierungen liegt darin begründet, dass zumindest in den Fällen der 4 Quadrate und der 6 Hexagone vergleichsweise wenige Segmente entlang des Umfangs verwendet werden. Die HALBACH Magnetisierung wird also auf 180° lediglich durch 2 bzw. 3 Segmente diskretisiert, was in einer starken Ausprägung der nächsthöheren tesseralen Feldordnungen resultiert, die unerwünscht sind. Die sich daraus ergebenden Defizite in der Grundhomogenität und im Streufeld müssen durch erhöhten Aufwand bei der Homogenisierung und Abschirmung ausgeglichen werden.

Es folgen nun einige Details zu den verschiedenen Schritten bei der Herstellung des erfindungsgemäßen Permanentmagnetsystems:
Herstellerseitig werden entweder direkt Magnete in die benötigte Form und Vorzugsrichtung gesintert, oder aus einem Plattenrohling herauserodiert. Im Anschluss werden Oberflächen üblicherweise veredelt um Korrosion zu verhindern (Ni-Cu-Ni).

Die Segmente sind zunächst unmagnetisiert, wobei die Vorzugsrichtung bekannt ist, etwa durch herstellerseitiges Aufbringen einer Strichmarkierung oder nach dem Ermitteln der Vorzugsrichtung durch Auspendeln im äußeren Magnetfeld.

Für den zu bestückenden Ring wird zunächst eine Montagereihenfolge für die durchnummerierten Segmente bestimmt. Die Reihenfolge kann frei bestimmt werden und wird vorzugsweise so festgelegt, dass Abstoßungs- und Anziehungskräfte zwischen bereits montierten Segmenten und dem hinzuzufügenden Segment minimiert werden.

Der Ringträger (Chassis mit entsprechenden Aussparungen zur Segmentaufnahme) ist auf einer motorisch verstellbaren Drehplattform befestigt, sodass die zu bestückende Position sich stets an den gleichen Ort drehen lässt, an dem das zu bestückende Segment mit Führung und Stößel eingeschoben wird (Revolvertrommelprinzip).

Für jede Position ist die Orientierung, mit der das jeweilige Segment bestückt werden muss, hinterlegt. Eine Steuerung stellt sicher, dass die Segmente in der korrekten Reihenfolge zugeführt werden. Dazu wird die aktuelle Bestückungsposition der Revolvertrommel sensorisch erkannt und an die Steuerung übermittelt. Ein unmagnetisiertes Segment wird aus dem Vorrat zugeführt und mit der benötigten Orientierung in die Magnetisierungsvorrichtung eingelegt. Eine motorisch verstellbare Aufnahme dreht das Segment entsprechend der hinterlegten Winkelinformation.

Zunächst wird durch die Steuerung der für die Magnetisierung richtige Winkel gewählt: z.B. Typ A = Nordpol auf Ecke, Typ B = Nordpol auf Kante. Dann wird die Magnetisierungsvorrichtung aktiviert und das Segment magnetisiert. Anschließend wird durch die Steuerung der für die Montage richtige Winkel ausgewählt und das Segment entsprechend gedreht. Schließlich wird das Segment in das Chassis eingeschoben und der Ablauf wiederholt sich bis der Ring komplett ist.

Dieses Verfahren lässt sich auch dahingehend gestalten, dass alle Segmente zunächst nacheinander magnetisiert werden und in einer Art Magazin mit der für die jeweilige Montageposition passenden Orientierung vorgelagert werden, und die Montage dann aus diesem Magazin erfolgt.

Weiterhin ist es bei entsprechender Platzverfügbarkeit in der Magnetisierungsvorrichtung denkbar, mehrere (oder gar alle) Segmente simultan zu magnetisieren (sofern eine separate Entnahme mit akzeptablem Kraftaufwand noch möglich ist).

Denkbar ist auch, die Montagezeit weiter zu verkürzen, indem man beispielsweise Segmente diametral paarweise bestückt, indem man die Bestückungshalterung dupliziert.

Dieser aus mehreren Stationen bestehende Montagezyklus, kann im Prinzip stationsweise oder komplett automatisiert werden, wodurch sich Bediensicherheit einerseits und Taktung andererseits deutlich erhöhen lassen.

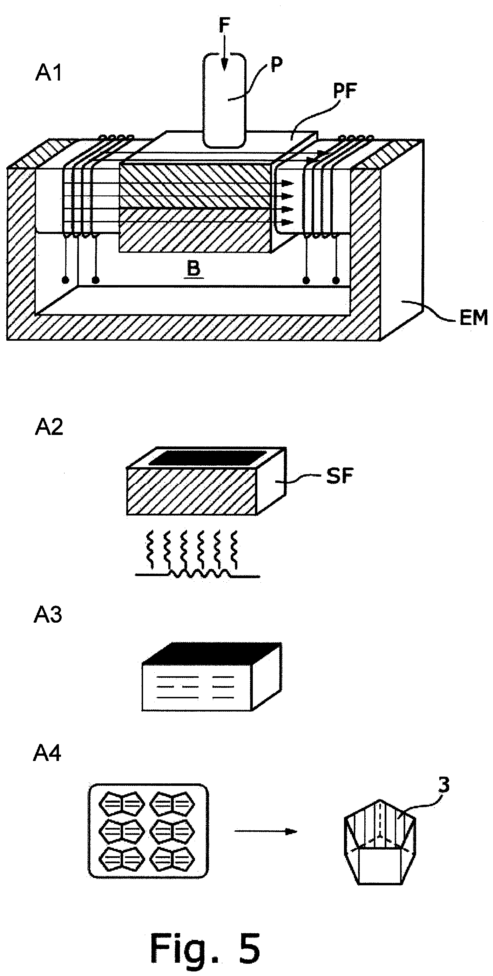

Fig. 5 illustriert die schematische Abfolge von Verfahrensschritten A1 bis A4 bei der Herstellung von prismatischen Magnetsegmenten.

Üblicherweise wird bei der Herstellung von Permanentmagneten mit Seltenerden eine Form mit einem Rohmaterial in Pulverform gefüllt, die anschließend zu dem Amalgam gesintert wird. Um der Magnetisierung eine Vorzugsrichtung zu geben -denn nur so erhält man eine maximale Remanenz des Materials- wird während des Sinterns ein äußeres Magnetfeld in der Vorzugsrichtung angelegt. Entlang dieser Vorzugsrichtung erfolgt die Aufmagnetisierung, wobei es unerheblich ist, in welcher Richtung Süd- oder Nordpol sind. Wesentlich ist nur die Einhaltung der Vorzugsrichtung.

Ein wichtiger Aspekt beim der Herstellung von erfindungsgemäßen Ringmagneten in Halbachkonfiguration ist, dass im ersten Schritt der Herstellung der Segmente die Vorzugsrichtung der Vormagnetisierung dieselbe ist, wie im späteren Folgeschritt bei der Aufmagnetisierung. Denn nur wenn diese Vorzugsrichtungen deckungsgleich sind, kann man die vollständige Remanenz des Magnetmaterials nutzen.

Wie in Fig. 5 angedeutet, erfolgt in einem ersten **Verfahrensschritt A1** mittels einer **Presse P** unter Einleitung einer **Kraft F** eine Formpressung des Sinterpulvers in einer **Pressform PF.** Gleichzeitig wird dabei mittels eines von einem **Elektromagneten EM** erzeugten **Magnetfeld B** eine Einprägung der gewünschten Vorzugsrichtung der Magnetisierung beim gepressten Rohling bewirkt.

In einem zweiten **Verfahrensschritt A2** wird der gepresste und mit einer eingeprägten magnetischen Vorzugsrichtung versehene Rohling in einer **Sinterform SF** erhitzt und -üblicherweise unter Schutzgas- gesintert und ausgehärtet.

Im dritten **Verfahrensschritt A3** erhält man dann einen fertigen Roh-Magneten zur Weiterverarbeitung.

Aus diesem Sinterblock-förmigen Roh-Magneten werden dann im **Verfahrensschritt A4** die Magnetsegmente hergestellt. In der Regel erfolgt hierbei -zumeist mittels Drahterosion- ein Zuschnitt der Vorprodukte für spätere Magnetsegmente 3 auf das gewünschte geometrische End-Maß.

Nach Festlegung der anwendungsspezifischen magnetischen Flussdichte wird geeignete eine Segmentierung gewählt. Der Innenradius richtet sich nach der benötigten Bohrung bzw. der Länge des Bereichs mit der erforderlichen Grundhomogenität. Alle Abmessungen leiten sich aus dem Radius der Bohrung ab.

Die benötigte axiale Länge richtet sich nach der benötigten Länge des Bereichs mit der erforderlichen Grundhomogenität. Um die axiale Länge und damit den Materialbedarf möglichst gering zu halten, ist eine Stapelung mehrerer Ringe zweckmäßig. Durch Variation der Radien und Längen der einzelnen Ringsektionen, lassen sich ringförmige Ausnehmungen (Notche) realisieren, die eine Verbesserung der Grundhomogenität bei gleichzeitig kürzerer Baulänge bewirken.

Die Vereinfachung des Herstellungsprozesses wird allerdings mit einer geringeren Flächenabdeckung des Magnetmaterials erkauft. Bei den Anordnungen mit sehr grober Stückelung wirkt sich das merklich auf die Materialeffizienz aus. Dabei ist insbesondere eine Realisierung mit 10 Pentagonen als besonders günstig hervorzuheben, weil hier die kleinsten Effizienzeinbußen hingenommen werden müssen.

Vorteilhaft für die Anwendung der Erfindung ist ein sequentieller Montagezyklus, der das polrichtige Magnetisieren der Segmente vornimmt und das anschließende Verbauen in einer geeigneten Haltestruktur. Aufgrund der erfindungsgemäß identischen Ausgangsbauteile und des repetitiven Charakters lässt sich der Montagezyklus vergleichsweise einfach automatisieren, da nur eine Fixiermechanik für Entnahme, Transport und Einsetzen benötigt wird.

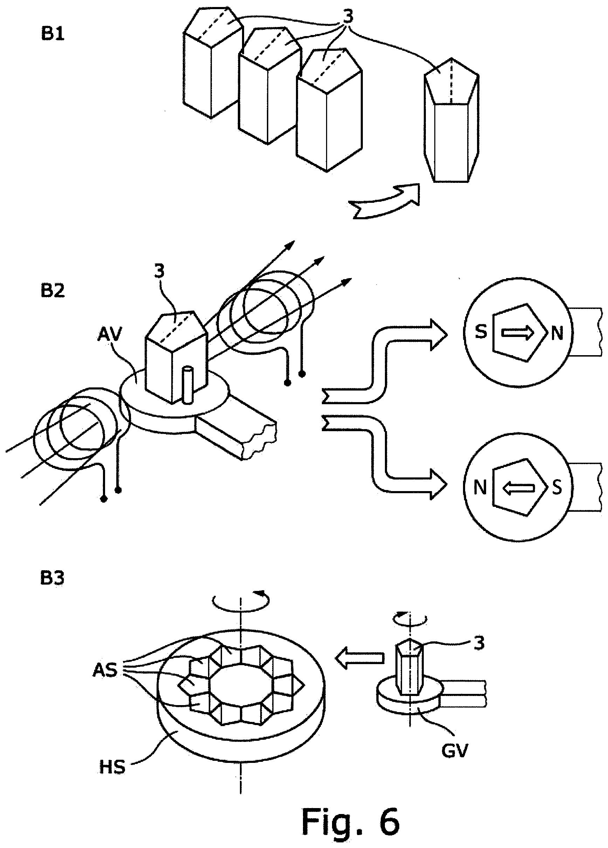

Fig. 6 illustriert die schematische Abfolge weiterer Verfahrensschritte B1 bis B3 bei der automatisierten Verarbeitung dieser prismatischen Vorprodukte identischer Form zu magnetisierten Magnetsegmenten 3 sowie anschließend zu einem ringförmigen Magnetelement.

In einem ersten **Verfahrensschritt B1** werden die in Schritt A4 hergestellten prismatischen Vorprodukte identischer Form -die bereits in Schritt A1 mit einer eingeprägten Vormagnetisierungsrichtung versehen wurden- angeliefert und vereinzelt. Die zunächst noch unmagnetisierten Segmente werden mit bekannter und vorzugsweise identischer Ausrichtung aus einer Verpackung bzw. von einem Transportband entnommen und mittels eines Greifarms fixiert.

In einem weiteren **Verfahrensschritt B2** wird dann ein solches Vorprodukt in die Aufnahmevorrichtung AV einer Magnetisierungsvorrichtung eingesetzt, in welcher -in der Regel mittels starker Elektromagneten-durch Magnetisierung des Vorprodukts das eigentliche Magnetsegment 3 erzeugt. In der Aufnahmevorrichtung AV wird dazu das -spätere- Magnetsegment 3 in eine gewünschte Position relativ zu dem in der Magnetisierungsvorrichtung erzeugten starken Magnetfeld ausgerichtet. Das Segment wird mittels Greifarm in die Magnetisiervorrichtung eingesetzt und entsprechend der vorgesehenen Montageposition polrichtig magnetisiert. Dies lässt sich beispielsweise über eine Rotationsmimik des Greifers bewerkstelligen, die das Segment vor dem Start des Magnetisiervorgangs wahlweise um 180° dreht.

Bei prismatischen Magnetsegmenten mit einem regelmäßig polygonalen Querschnitt und einem ungeradzahligen Polygon sind dabei zwei Fälle zu unterscheiden:

Entweder soll die Magnetisierung des fertigen Magnetsegments in Süd-Nord-Richtung von einer Kante zu einer gegenüberliegenden Ecke verlaufen (oberes rechtes Teilbild zu Schritt B2)
oder von einer Ecke zu einer gegenüberliegenden Kante (unteres rechtes Teilbild).

Die fertig magnetisierten Magnetsegmente 3 werden dann in einem anschließenden **Verfahrensschritt B3** mittels einer Greifvorrichtung GV automatisiert aufgenommen, positioniert und in die passgenauen Aussparungen AS einer Haltestruktur HS eingefügt. Um alle Aussparungen AS sukzessive mit entsprechend positionierten Magnetsegmenten 3 automatisiert bestücken zu können, verfügt die Haltestruktur HS ebenfalls über eine Rotationsmimik, welche die Haltestruktur an die vorgesehene Winkelposition dreht. Gleichzeitig wird der Greifarm mit seiner eigenen Rotationsmimik so gedreht, dass die Magnetisierungsrichtung des Segments zur vorgesehenen Montageposition passt.

Diese Schritte werden zyklisch wiederholt, bis alle Segmente zu einem Ring verbaut sind. Die Reihenfolge lässt sich für die eine Minimierung der auftretenden Montagekräfte beliebig variieren. Das Einstellen der Winkelpositionen von Greifer und Haltestruktur erfolgt vorzugsweise durch eine elektronische Steuerung und aufeinander abgestimmt.

Die geometrischen Eigenschaften der erfindungsgemäßen Polygonsegmente haben unter anderem auch Vorteile im Hinblick auf ihre Fixierung in der äußeren Haltestruktur. Hinzu kommt, dass beim Zusammensetzen der Magnetanordnung erhebliche Kräfte auftreten, die der zu erzielenden Ausrichtung entgegenwirken. Eine formschlüssige Fixierung, stellt daher auch einen wichtigen Sicherheitsaspekt dar. Dies wird sowohl bei Montage als auch danach durch die erfindungsgemäß gewählte Polygongeometrie unterstützt.

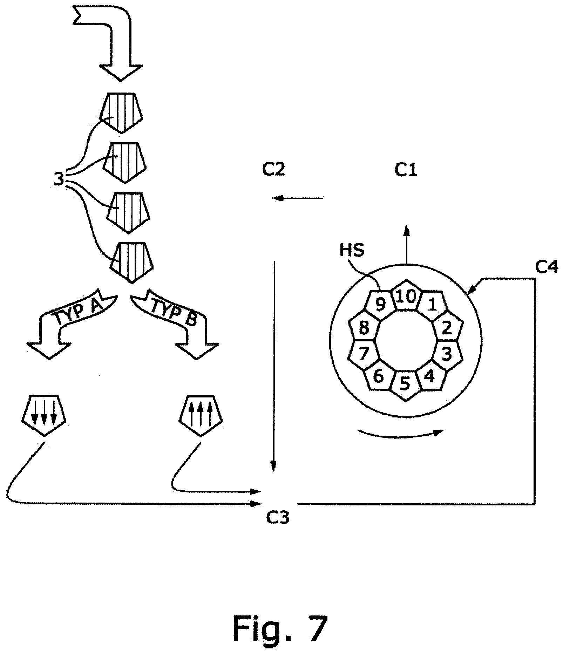

<u>Fig. 7</u> illustriert die Abfolge von Verfahrensschritten C1 bis C4 bei der Verarbeitung prismatischer Magnetsegmente 3 zu einem ringförmigen Magnetelement im oben unter Schritt B2 beschriebenen Sonderfall zweier entgegengesetzter Magnetisierungstypen (Typ A und Typ B) der Magnetsegmente 3.

Auf der linken Seite des Bildes ist oben mit einem gekrümmten Pfeil die Anlieferung von bereits vereinzelten Vorprodukten der späteren Magnetsegmente 3 angedeutet. In der Regel sind sie in diesem Stadium der Herstellung auf Maß geschnitten und ihre Oberflächen schon mit einem Korrosionsschutz beschichtet. Diese Vorprodukte der Magnetsegmente 3 werden dann entsprechend dem gewünschten Typ A oder Typ B in der entsprechenden Richtung oder deren Gegenrichtung magnetisiert.

In einem ersten **Verfahrensschritt C1** wird die aktuelle Montageposition zum Einsetzen eines Magnetsegments 3 in eine bestimmte Aussparung AS der Haltestruktur Herr Steinhardt bestimmt.

Dann wird im **Verfahrensschritt C2** die gewünschte Magnetisierungsachse festgelegt.

Anschließend wird in **Verfahrensschritt C3** der aktuell zu verarbeitende Typ A oder B des aktuell nächsten einzubauenden Magnetsegments 3 ausgewählt.

Schließlich wird dann in **Verfahrensschritt C4** dieses ausgewählte Magnetsegment 3 in eine freie Aussparung AS der entsprechend vorpositionierten Haltestruktur HS eingelegt und montiert. Im dargestellten Ausführungsbeispiel wird auf diese Weise die Haltestruktur Herr Steinhardt sukzessive mit insgesamt 10 pentagonal-prismatischen Magnetsegmenten 3 immer im Wechsel von Magnetisierungstyp A und B vollständig bestückt. Damit ist dann die Herstellung eines erfindungsgemäßen ringförmigen Magnetelements 2 im Wesentlichen abgeschlossen.

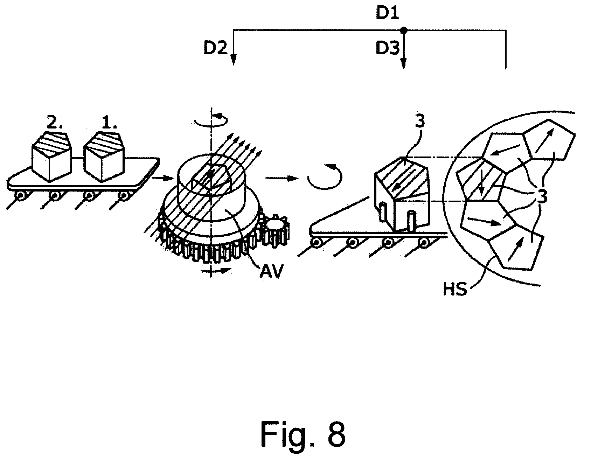

<u>Fig. 8</u> schließlich illustriert die Abfolge von Verfahrensschritten D1 bis D3 bei der Magnetisierung von prismatischen Magnetsegmenten 3 sowie dem winkelrichtigen Zusammenfügen zu einem ringförmigen Magnetelement 2.

In **Verfahrensschritt D1** wird die gewünschte Einbauposition eines Magnetsegments 3 bestimmt. Sodann erfolgt in **Verfahrensschritt D2** eine Ausrichtung der Aufnahmevorrichtung Arbeitsvolumen zur Magnetisierung des Magnetsegments. Anschließend wird dann in **Verfahrensschritt D3** dieses nunmehr magnetisierte Magnetsegment 3 zur Montage in der Haltestruktur HS weiterbefördert, wo die HALBACH-Anordnung eines erfindungsgemäßen ringförmigen Magnetelement 2 hergestellt wird.

**Bezugszeichenliste**

| | |
|---|---|
| 0; 0'; 0"; 0"'; 0"" | Messvolumen |
| 1; 1'; 1"; 1"'; 1"" | Magnetanordnung |
| 2; 2a', 2b'; 2"; 2"'; 2"" | ringförmige Magnetelemente |
| 3; 3a', 3b'; 3"; 3"'; 3"" | Magnetsegmente |

| | |
|---|---|
| AV | Aufnahmevorrichtung |

HS    Haltestruktur
AS    Aussparungen
GV    Greifvorrichtung

P    Presse
F    Krafteinleitung in die Presse
PF    Pressform
B    Magnetfeld zur Einprägung einer Vorzugsrichtung
EM    Elektromagnet
SF    Sinterform

**Verfahrensschritte**

A1    Pressen
A2    Sintern und Aushärten
A3    Rohmagnet mit Vorzugsrichtung zur Weiterbearbeitung
A4    Zuschnitt von Magnetsegmenten auf Maß

B1    Vereinzeln von identischen Magnetsegmenten
B2    Magnetisieren der Magnetsegmente in einer Aufnahmevorrichtung
B3    Einsetzen der Magnetsegmente in eine Haltestruktur
C1    Einstellen der aktuellen Montageposition zum Einsetzen eines Magnetsegments in eine Aussparung der Haltestruktur
C2    Festlegen der gewünschten Magnetachse
C3    Auswählen eines von zwei Typen der vormagnetisierten Magnetsegmente
C4    Montieren des ausgewählten Magnetsegments in der Haltestruktur

D1    Bestimmen der gewünschten Einbauposition eines Magnetsegments
D2    Ausrichtung der Aufnahmevorrichtung zur Magnetisierung des Magnetsegments
D3    Ausrichtung des magnetisierten Magnetsegments für die Montage in der Haltestruktur

**Referenzliste:**

Für die Beurteilung der Patentfähigkeit in Betracht gezogene Druckschriften

[1] US 8,712,706 B2
[2] US 9,952,294 B2
[3] EP 3 657 194 B1 ≈ US 10,976,391 B2
[4] EP 3 614 162 A1 ≈ US 11,193,998 B2
[5] US 2010/013473 A1
[6] US 5,119,057 A
[7] WO 2007/120057 A1
[8] EP 2 365 353 A1
[9] WO 2013/187924 A1
[10] US 2018/0313920 A1
[11] US 5 705 902 A
[12] BAUN OLGA ET AL: "Permanent magnet system to guide superparamagnetic particles",

    JOURNAL OF MAGNETISM AND MAGNETIC MATERIALS, ELSEVIER, AMSTERDAM, NL,
    Bd. 439, 4. Mai 2017 (2017-05-04), Seiten 294-304, XP085050068, ISSN: 0304-8853, DOI: 10.1016/J.JMMM.2017.05.001

[13] BLÜMLER PETER: "Proposal for a permanent magnet system with a constant gradient mechanically adjustable in direction and strength",

    CONCEPTS IN MAGNETIC RESONANCE PART B: MAGNETIC RESONANCE ENGINEERING,

Bd. 46, Nr. 1, 27. Februar 2016 (2016-02-27), Seiten 41-48, XP055969504, US
ISSN: 1552-5031, DOI: 10.1002/cmr.b.21320

[14] RAICH H ET AL: "Design and construction of a dipolar Halbach array with a homogeneous field from identical bar magnets: NMR Mandhalas", CONCEPTS IN MAGNETIC RESONANCE, NMR CONCEPTS, KINGSTON, RI, US,

Bd. 23B, Nr. 1, 1. Januar 2004 (2004-01-01), Seiten 16-25, XP008084096,
ISSN: 1043-7347

**Patentansprüche**

1. Permanentmagnetsystem mit einer ringförmig um eine z-Achse aufgebauten Magnetanordnung (1; 1'; 1"; 1'''; 1'''') zur Erzeugung eines homogenen Magnetfeldes in einer Richtung senkrecht zur z-Achse in einem Messvolumen (0; 0'; 0"; 0'''; 0'''') innerhalb der ringförmigen Magnetanordnung (1; 1'; 1"; 1'''; 1''''), welche mindestens ein ringförmiges Magnetelement (2; 2a', 2b'; 2"; 2'''; 2'''') mit magnetischem Material in einer Ringebene umfasst, das in einer Halbach-Konfiguration eine Anzahl n nebeneinander sowie jeweils mit Flächenanlage angeordnete einzelne Magnetsegmente (3; 3a', 3b'; 3"; 3'''; 3'''') aufweist, die im Umlauf um das ringförmige Magnetelement (2; 2a', 2b'; 2"; 2'''; 2"") gemäß den Regeln einer Halbach-Anordnung sich ändernde Magnetisierungsrichtungen haben, die zusammen ein magnetisches Dipolfeld in der Ringebene der ringförmigen Magnetanordnung (1; 1'; 1"; 1'''; 1'''') erzeugen, und die untereinander gleiche polyedrische Geometrie und in der Ringebene jeweils einen identischen, konvexen, regelmäßig polygonalen Querschnitt aufweisen,
**dadurch gekennzeichnet,**
**dass** die Magnetsegmente (3; 3a', 3b'; 3"; 3'''; 3'''') in der Ringebene jeweils einen untereinander identischen, konvexen, regelmäßig pentagonalen oder heptagonalen Querschnitt aufweisen.

2. Permanentmagnetsystem nach Anspruch 1, **dadurch gekennzeichnet, dass** die magnetische Vorzugsrichtung jedes der polyedrischen Magnetsegmente (3; 3a', 3b'; 3"; 3''') jeweils in der Ringebene längs einer der Mittelsenkrechten des jeweiligen polygonalen Querschnitts verläuft.

3. Permanentmagnetsystem nach Anspruch 1 oder 2, **dadurch gekennzeichnet, dass** die Form des Querschnitts der untereinander geometrisch identischen Magnetsegmente (3; 3a', 3b'; 3"; 3"") in der Ringebene

   - entweder pentagonal ist und die Anzahl n=10 beträgt,
   - oder heptagonal ist und die Anzahl n=14 beträgt.

4. Permanentmagnetsystem nach einem der vorhergehenden Ansprüche, **dadurch gekennzeichnet, dass** ein radial inneres, aus n Magnetsegmenten (3b') aufgebautes Magnetelement (2b') der ringförmigen Magnetanordnung (1') koaxial zur z-Achse von einem radial äußeren, aus n' Magnetsegmenten (3a') aufgebauten Magnetelement (2a') umgeben ist.

5. Permanentmagnetsystem nach einem der vorhergehenden Ansprüche, **dadurch gekennzeichnet, dass** in der Magnetanordnung (1; 1'; 1"; 1'''; 1'''') mindestens zwei ringförmige Magnetelemente (2; 2a', 2b'; 2"; 2'''; 2'''') mit Abstand voneinander in axialer Richtung der z-Achse angeordnet sind.

6. Verfahren zur Herstellung eines Permanentmagnetsystems nach Anspruch 1,
**gekennzeichnet durch folgende Schritte:**

   a) Bereitstellung der aus Rohmaterial in Pulverform, insbesondere Seltenerden, zu einem Amalgam gesinterten Magnetsegmente (3; 3a', 3b'; 3"; 3'''; 3'''') gleicher polyedrischer Geometrie und einer magnetischen Vorzugsrichtung, welche jeweils in der Ringebene längs einer der Mittelsenkrechten des jeweiligen polygonalen Querschnitts verläuft;
   b) Aufmagnetisierung der Magnetsegmente (3; 3a', 3b'; 3"; 3'''; 3"") in einer Aufnahmevorrichtung (AV) parallel oder antiparallel zur magnetischen Vorzugsrichtung;
   c) Montage des ringförmigen Magnetelements (2; 2a', 2b'; 2"; 2'''; 2"") aus n Magnetsegmenten (3; 3a', 3b'; 3"; 3''''; 3"") in einer Haltestruktur (HS).

7. Verfahren nach Anspruch 6, **dadurch gekennzeichnet, dass** die Haltestruktur (HS) n auf die geometrische Form der Magnetsegmente (3; 3a', 3b'; 3"; 3'''; 3'''') passgenau abgestimmte Aussparungen (AS) zur formschlüssigen Fixierung der Magnetsegmente (3; 3a', 3b'; 3"; 3'''; 3'''') aufweist.

8. Verfahren nach Anspruch 7, **dadurch gekennzeichnet, dass** die n Magnetsegmente (3; 3a', 3b'; 3"; 3'''; 3'''') in Montageschritt c) mittels einer, vorzugsweise automatisch betreibbaren, Greifvorrichtung (GV) sequentiell aufgenommen und in die Aussparungen (AS) der Haltestruktur (HS) eingesetzt werden.

9. Verfahren nach Anspruch 8, **dadurch gekennzeichnet, dass** die Haltestruktur (HS) und/oder die Greifvorrichtung (GV) beim sequentiellen Montagevorgang um eine Achse parallel zur z-Achse der Magnetanordnung (1; 1'; 1"; 1'''; 1'''') rotiert wird.

10. Verfahren nach einem der Ansprüche 6 bis 9, **dadurch gekennzeichnet, dass** in einem Zwischenschritt a') vor dem Aufmagnetisieren der Magnetsegmente (3; 3a', 3b'; 3"; 3'''; 3'''') eine äußerliche Nachbearbeitung der Flächen und/oder Kanten der polyedrischen Magnetsegmente (3; 3a', 3b'; 3"; 3'''; 3'''') erfolgt, vorzugsweise durch Erodieren, Schleifen oder Fräsen.

11. Verfahren nach einem der Ansprüche 6 bis 10, **dadurch gekennzeichnet, dass** in einem Zwischenschritt a") während des Sinterns der Magnetsegmente (3; 3a', 3b'; 3"; 3'''; 3'''') ein schwaches äußeres Magnetfeld in einer Vorzugsrichtung angelegt und die Magnetsegmente (3; 3a', 3b'; 3"; 3'''; 3'''') dadurch vormagnetisiert werden, wobei vorzugsweise die Vorzugsrichtung der Vormagnetisierung der Magnetsegmente (3; 3a', 3b'; 3"; 3'''; 3'''') dieselbe ist wie die Richtung der Aufmagnetisierung in Schritt b).

12. Verfahren nach einem der Ansprüche 6 bis 11, **dadurch gekennzeichnet, dass** die Form des Querschnitts der untereinander geometrisch identischen Magnetsegmente (3; 3a', 3b'; 3") in der Ringebene entweder pentagonal ist und die Anzahl n=10 beträgt, oder heptagonal ist und die Anzahl n=14 beträgt, und dass die Aufmagnetisierung der Magnetsegmente (3; 3a', 3b'; 3") in Schritt b) entweder in einer Richtung von einer Seitenfläche zu einer gegenüberliegenden Seitenkante des jeweils ungeradzahlig polyedrischen Magnetsegments (3; 3a', 3b'; 3") oder in der Gegenrichtung, also von einer Seitenkante zu einer gegenüberliegenden Seitenfläche, erfolgt.

13. Verfahren nach Anspruch 12, **dadurch gekennzeichnet, dass** die sequentielle Aufmagnetisierung der Magnetsegmente (3; 3a', 3b'; 3") in Schritt b) immer abwechselnd in einer Richtung oder der Gegenrichtung erfolgt.

## Claims

1. Permanent magnet system comprising a magnet arrangement (1; 1'; 1"; 1'''; 1'''') which is constructed in a ring around a z-axis for generating a homogeneous magnetic field in a direction perpendicular to the z-axis in a measuring volume (0; 0'; 0"; 0'''; 0'''') within the ring-shaped magnet arrangement (1; 1'; 1"; 1'''; 1''''), which arrangement comprises at least one ring-shaped magnet element (2; 2a'; 2b'; 2"; 2'''; 2'''') having magnetic material in a ring plane, comprising a number n of individual magnet segments (3; 3a', 3b'; 3"; 3'''; 3'''') in a Halbach configuration, which are arranged adjacently to one another and in each case having surface contact, which magnet segments have changing magnetization directions in rotation about the ring-shaped magnet element (2; 2a', 2b'; 2"; 2'''; 2''''), according to the rules of a Halbach arrangement, and together generate a magnetic dipole field in the ring plane of the ring-shaped magnet arrangement (1; 1'; 1"; 1'''; 1''''), and which have the same polyhedral geometry and an identical, convex, regular polygonal cross section in the ring plane in each case,
**characterized in that**
the magnet segments (3; 3a', 3b'; 3"; 3'''; 3'''') each have an identical, convex, regularly pentagonal or heptagonal cross section in the ring plane.

2. Permanent magnet system according to claim 1, **characterized in that** the preferred magnetic direction of each of the polyhedral magnet segments (3; 3a', 3b'; 3"; 3'''; 3'''') extends in the ring plane along one of the perpendicular bisectors of the relevant polygonal cross section.

3. Permanent magnet system according to either claim 1 or claim 2,
**characterized in that** the shape of the cross section of the geometrically identical magnet segments (3; 3a', 3b'; 3"; 3'''') in the ring plane

- is either pentagonal and the number n=10,
- or is heptagonal and the number n=14.

4. Permanent magnet system according to any of the preceding claims, **characterized in that** a radially inner magnet element (2b') of the ring-shaped magnet arrangement (1'), made up of n magnet segments (3b'), is surrounded coaxially to the z-axis by a radially outer magnet element (2a') made up of n' magnet segments (3a').

5. Permanent magnet system according to any of the preceding claims, **characterized in that** in the magnet arrangement (1; 1'; 1"; 1'''; 1''''), at least two ring-shaped magnet elements (2; 2a', 2b'; 2"; 2'''; 2'''') are arranged at a distance from one another in the axial direction of the z-axis.

6. Method for producing a permanent magnet system according to claim 1,
   **characterized by the following steps:**

   a) providing the magnet segments (3; 3a', 3b'; 3"; 3'''; 3'''') which are sintered from raw material in powder form, in particular rare earth metals, to form an amalgam, and have the same polyhedral geometry and a preferred magnetic direction which extends in the ring plane along one of the perpendicular bisectors of the relevant polygonal cross section;
   b) magnetizing the magnet segments (3; 3a', 3b'; 3"; 3'''; 3'''') in a receiving device (AV) parallel or antiparallel to the preferred magnetic direction;
   c) assembling the ring-shaped magnet element (2; 2a', 2b'; 2"; 2'''; 2'''') from n magnet segments (3; 3a', 3b'; 3"; 3'''; 3'''') in a holding structure (HS).

7. Method according to claim 6, **characterized in that** the holding structure (HS) has n recesses (AS) which are precisely matched to the geometric shape of the magnet segments (3; 3a', 3b'; 3"; 3'''; 3'''') for fixing the magnet segments (3; 3a', 3b'; 3"; 3'''; 3'''') in a form-fitting manner.

8. Method according to claim 7, **characterized in that** the n magnet segments (3; 3a', 3b'; 3"; 3'''; 3'''') in assembly step c) are received sequentially by means of a preferably automatically operable gripping device (GV) and are inserted into the recesses (AS) of the holding structure (HS).

9. Method according to claim 8, **characterized in that** the holding structure (HS) and/or the gripping device (GV) is rotated about an axis parallel to the z-axis of the magnet arrangement (1; 1'; 1"; 1'''; 1'''') during the sequential assembly process.

10. Method according to any of claims 6 to 9, **characterized in that** in an intermediate step a') before magnetizing the magnet segments (3; 3a', 3b'; 3"; 3'''; 3''''), an external post-processing of the surfaces and/or edges of the polyhedral magnet segments (3; 3a', 3b'; 3"; 3'''; 3'''') is carried out, preferably by erosion, grinding or milling.

11. Method according to any of claims 6 to 10, **characterized in that** in an intermediate step a") during the sintering of the magnet segments (3; 3a', 3b'; 3"; 3'''; 3''''), a weak external magnetic field is applied in a preferred direction and the magnet segments (3; 3a', 3b'; 3"; 3'''; 3'''') are thereby pre-magnetized, the preferred direction of the pre-magnetization of the magnet segments (3; 3a', 3b'; 3"; 3'''; 3'''') preferably being the same as the direction of the magnetization in step b).

12. Method according to any of claims 6 to 11, **characterized in that** the shape of the cross section of the geometrically identical magnet segments (3; 3a', 3b'; 3") in the ring plane is either pentagonal and the number n=10, or is heptagonal and the number n=14, and **in that** the magnetization of the magnet segments (3; 3a', 3b'; 3") in step b) takes place either in a direction from one side surface to an opposite side edge of the in each case odd-numbered polyhedral magnet segment (3; 3a', 3b'; 3") or in the opposite direction, i.e. from one side edge to an opposite side surface.

13. Method according to claim 12, **characterized in that** the sequential magnetization of the magnet segments (3; 3a', 3b'; 3") in step b) always takes place alternately in one direction or the opposite direction.

**Revendications**

1. Système d'aimant permanent comprenant un agencement d'aimants (1 ; 1' ; 1" ; 1''' ; 1'''') construit de manière annulaire autour d'un axe z et permettant de générer un champ magnétique homogène dans une direction perpendiculaire à l'axe z au sein d'un volume de mesure (0 ; 0' ; 0" ; 0‴ ; 0⁗) situé à l'intérieur de l'agencement d'aimants annulaire (1 ; 1' ; 1" ; 1‴ ; 1⁗), qui comprend au moins un élément magnétique annulaire (2 ; 2a', 2b' ; 2" ; 2‴ ; 2⁗) avec un matériau magnétique dans un plan annulaire, ledit élément magnétique annulaire présentant en configuration Halbach un nombre n de segments magnétiques (3 ; 3a', 3b' ; 3" ; 3‴ ; 3⁗) individuels, qui sont agencés côte à côte et respectivement de manière à présenter un contact superficiel et présentent des directions de magnétisation se modifiant tout autour de l'élément magnétique annulaire (2 ; 2a', 2b' ; 2" ; 2‴ ; 2⁗) conformément aux règles d'un réseau de Halbach et produisant ensemble un champ magnétique dipolaire dans le plan annulaire de l'agencement d'aimants annulaire (1 ; 1' ; 1" ; 1‴ ; 1⁗) et présentant des géométries polyédriques identiques les unes aux autres et respectivement une section transversale polygonale convexe régulière identique dans le plan annulaire, **caractérisé en ce que**

les segments magnétiques (3 ; 3a', 3b' ; 3" ; 3‴ ; 3⁗) présentent respectivement une section transversale pentagonale ou heptagonale régulière convexe identique dans le plan annulaire.

2.  Système d'aimant permanent selon la revendication 1, **caractérisé en ce que** la direction magnétique préférentielle de chacun des segments magnétiques (3 ; 3a', 3b' ; 3" ; 3‴ ; 3⁗) polyédriques s'étend respectivement dans le plan annulaire le long de l'une des médiatrices de la section transversale polygonale respective.

3.  Système d'aimant permanent selon la revendication 1 ou 2, **caractérisé en ce que** la forme de la section transversale des segments magnétiques (3 ; 3a', 3b' ; 3" ; 3⁗) géométriquement identiques les uns aux autres est, dans le plan annulaire,

    - pentagonale et le nombre n=10,
    - ou heptagonale et le nombre n=14.

4.  Système d'aimant permanent selon l'une quelconque des revendications précédentes, **caractérisé en ce qu'**un élément magnétique (2b') radialement intérieur, constitué de n segments magnétiques (3b'), de l'agencement d'aimants annulaire (1') est entouré, de manière coaxiale par rapport à l'axe z, par un élément magnétique (2a') radialement extérieur constitué de n' segments magnétiques (3a').

5.  Système d'aimant permanent selon l'une quelconque des revendications précédentes, **caractérisé en ce que** au moins deux éléments magnétiques annulaires (2 ; 2a'; 2b' ; 2" ; 2‴ ; 2⁗) sont agencés au sein de l'agencement d'aimants (1 ; 1' ; 1" ; 1‴ ; 1⁗) à distance l'un de l'autre dans la direction axiale de l'axe z

6.  Procédé de fabrication d'un système d'aimant permanent selon la revendication 1, **caractérisé par** les étapes ci-dessous consistant à :

    a) fournir des segments magnétiques (3 ; 3a' ; 3b' ; 3"; 3‴ ; 3⁗) frittés pour obtenir un amalgame à partir de matières premières sous forme de poudre, en particulier de terres rares, de géométrie polyédrique identique et présentant une direction magnétique préférentielle qui s'étend respectivement dans le plan annulaire le long de l'une des médiatrices de la section transversale polygonale respective ;
    b) magnétiser les segments magnétiques (3 ; 3a', 3b' ; 3" ; 3‴ ; 3⁗) au sein d'un dispositif d'accueil (AV) de manière parallèle ou antiparallèle par rapport à la direction magnétique préférentielle ;
    c) assembler l'élément magnétique annulaire (2 ; 2a', 2b' ; 2" ; 2‴ ; 2⁗) à partir de n segments magnétiques (3 ; 3a', 3b' ; 3" ; 3‴ ; 3⁗) au sein d'une structure de retenue (HS).

7.  Procédé selon la revendication 6, **caractérisé en ce que** la structure de retenue (HS) présente n évidements (AS) adaptés avec précision à la forme géométrique des segments magnétiques (3 ; 3a', 3b' ; 3" ; 3‴ ; 3⁗) et permettant d'immobiliser les segments magnétiques (3 ; 3a', 3b' ; 3" ; 3‴; 3⁗) avec un verrouillage par complémentarité de forme.

8.  Procédé selon la revendication 7, **caractérisé en ce que** les n segments magnétiques (3 ; 3a', 3b' ; 3" ; 3‴ ; 3⁗) sont accueillis de manière séquentielle à l'étape d'assemblage c) au moyen d'un dispositif de préhension (GV), de manière préférée à fonctionnement automatique, et insérés dans les évidements (AS) de la structure de retenue (HS).

9.  Procédé selon la revendication 8, **caractérisé en ce que** la structure de retenue (HS) et/ou le dispositif de préhension (GV) est/sont amené(s) à pivoter autour d'un axe parallèle à l'axe z de l'agencement d'aimants (1 ; 1' ; 1" ; 1‴ ; 1⁗) lors de l'opération d'assemblage séquentielle.

**10.** Procédé selon l'une quelconque des revendications 6 à 9, **caractérisé en ce que**, dans une étape intermédiaire a') précédant la magnétisation des segments magnétiques (3 ; 3a', 3b' ; 3" ; 3‴ ; 3""), un post-traitement extérieur des surfaces et/ou des bords des segments magnétiques (3 ; 3a', 3b' ; 3" ; 3‴ ; 3"") polyédriques est mis en oeuvre, de manière préférée par érosion, meulage ou fraisage.

**11.** Procédé selon l'une quelconque des revendications 6 à 10, **caractérisé en ce que**, dans une étape intermédiaire a") se déroulant pendant le frittage des segments magnétiques (3 ; 3a', 3b' ; 3" ; 3‴ ; 3""), un champ magnétique extérieur faible est appliqué dans une direction préférentielle et les segments magnétiques (3 ; 3a', 3b' ; 3" ; 3‴ ; 3"") sont ainsi polarisés, la direction préférentielle de la polarisation des segments magnétiques (3 ; 3a', 3b' ; 3" ; 3‴ ; 3"") étant de manière préférée la même que la direction de magnétisation à l'étape b).

**12.** Procédé selon l'une quelconque des revendications 6 à 11, **caractérisé en ce que** la forme de la section transversale des segments magnétiques (3 ; 3a', 3b' ; 3") géométriquement identiques les uns aux autres est, dans le plan annulaire, pentagonale et le nombre n=10 ou heptagonale et le nombre n=14, et **en ce que** la magnétisation des segments magnétiques (3 ; 3a', 3b' ; 3") à l'étape b) intervient dans une direction allant d'une surface latérale à un bord latéral opposé du segment magnétique (3 ; 3a', 3b' ; 3") polyédrique respectivement impair ou dans la direction opposée, c'est-à-dire allant d'un bord latéral à une surface latérale opposée.

**13.** Procédé selon la revendication 12, **caractérisé en ce que** la magnétisation séquentielle des segments magnétiques (3 ; 3a', 3b' ; 3") à l'étape b) intervient toujours de manière alternée dans une direction ou dans la direction opposée.

Fig. 1a

Fig. 1b

1"

2"

3"

0"

Fig. 2

1""

2""

3""

0""

3""

Fig. 3a

1""""

2""""

3""""

0""""

Fig. 3b

Fig. 4

**Fig. 5**

Fig. 6

Fig. 7

D1

D2

D3

2.  1.

3

AV

3

HS

# Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8712706 B2
- US 9952294 B2
- EP 3657194 B1
- US 10976391 B2
- EP 3614162 A1
- US 11193998 B2
- US 2010013473 A1
- US 5119057 A
- WO 2007120057 A1
- EP 2365353 A1
- WO 2013187924 A1
- US 20180313920 A1
- US 5705902 A

**In der Beschreibung aufgeführte Nicht-Patentliteratur**

- **BAUN OLGA et al.** *Permanent magnet system to guide superparamagnetic particles*
- **RAICH H et al.** *Design and construction of a dipolar Halbach array with a homogeneous field from identical bar magnets: NMR Mandhalas*
- Permanent magnet system to guide superparamagnetic particles. **BAUN OLGA**. JOURNAL OF MAGNETISM AND MAGNETIC MATERIALS. EL-SEVIER, 04 May 2017, 20170504
- **BLÜMLER PETER**. Proposal for a permanent magnet system with a constant gradient mechanically adjustable in direction and strength. *CONCEPTS IN MAGNETIC RESONANCE PART B: MAGNETIC RESONANCE ENGINEERING*, 27 February 2016, vol. 46 (1), 41-48
- **RAICH H et al.** Design and construction of a dipolar Halbach array with a homogeneous field from identical bar magnets: NMR Mandhalas. *CONCEPTS IN MAGNETIC RESONANCE, NMR CONCEPTS, KINGSTON*, 01 January 2004, vol. 23 (1)